# EUROPEAN PATENT APPLICATION

(11) **EP 1 818 972 A1**
(43) Date of publication of application: **15.08.2007**
(21) Application number: 05811512.2
(22) Date of filing: 30.11.2005
(51) Int. Cl.: H01L 21/027, G03F 7/20, H01L 21/02, H01L 21/66

(54) **DEVICE PROCESSING SYSTEM, INFORMATION DISPLAY METHOD, PROGRAM, AND RECORDING MEDIUM**

(30) Priority: 30.11.2004 JP 2004346061
(71) Applicant: NIKON CORPORATION, Tokyo 100-8831 (JP)
(72) Inventor: YASUKAWA, Koji c/o NIKON CORPORATION, Chiyoda-ku, Tokyo (JP); SUZUKI, Hiroyuki c/o NIKON CORPORATION, 3-chome, Chiyoda-ku, Tokyo (JP)
(74) Representative: HOFFMANN EITLE
(86) International application number: PCT/JP2005/021961
(87) International publication number: WO 2006/059625

(57) **Abstract**

A support device that is provided in a device manufacturing plant collects data from a device processing apparatus and analyzes the operating state and the like of the device processing apparatus based on the collected data. This support device consists of a data collection condition setting portion (231) that sets collection conditions of data to be used by the device processing apparatus; a statistical processing condition setting portion (232) that sets the processing condition of statistical processing to be performed on the collected data; and a graph display condition setting portion (233) that sets display conditions for displaying the collected data or the processing result of the statistical processing.

## Description

### TECHNICAL FIELD

The present invention relates to a device processing system provided with a device processing apparatus such as an exposure apparatus to be used when manufacturing an image pickup device such as a semiconductor element, a liquid crystal display element, and a charge coupled device (CCD), a plasma display device and a device such as thin film magnetic head; to an information display method that displays various types of information to be used in the device processing apparatus; to a program; and to a recording medium recorded with, in a state readable by a computer system, a program for making the computer system execute the information display method.

Priority is claimed on Japanese Patent Application No. 2004-346061, filed November 30, 2004, the content of which is incorporated herein by reference.

### BACKGROUND ART

In order to raise the utilization rate of a device processing apparatus such as an exposure apparatus, diagnostic systems and apparatus support systems have been introduced in systems having a plurality of lines. Such diagnostic systems and apparatus support systems collect various types of data from the devices via a network, with the data being analyzed in a server device and the like to grasp the situation and perform adjustment of control parameters. Specifically, such an apparatus support system (1) analyses and grasps the operating condition of the device and (2) statistically analyzes trends of the device data, and displays the analysis result for use in abnormality analysis (for example, see Patent Document 1).
Patent Document 1: Japanese Patent No. 336436

### DISCLOSURE OF INVENTION

### PROBLEMS TO BE SOLVED BY THE INVENTION

The conventional systems mentioned above do not examine the collection conditions of data used in the device processing apparatus, the processing conditions of the statistical processing performed on the collected data, the display conditions when displaying the collected data or the processing result of the statistical processing, and the report notification conditions. For that reason, although it is possible to collect data previously determined and perform statistical processing, display the collected data or result of statistical processing in a previously determined display format, and give notice of the report of the content previously determined, a user cannot freely perform collection of other data and the like in order to analyze and grasp the operating condition of the device processing apparatus.

In the event of changing the aforementioned conditions, it is necessary for a user to request the manufacturer of the device processing apparatus to make a change to the settings of the control parameters or change the program, and the manufacturer of the device processing apparatus to change the settings of the control parameters or change the program in accordance with this request. However, different users have different change requests, and it is conceivable for the change request of an individual user to frequently change. It is therefore difficult for a manufacturer of a device processing apparatus to comply with all user requests.

When a user does not suitably grasp the operating condition of a device processing apparatus, responses to exposure processing based on diagnoses and the like are delayed. That is, the timing of control measures such as feedback is delayed. Stated differently, the length of time from the occurrence of a problem to a response thereto becomes longer, preventing the efficient manufacture of devices and the like. Also, this situation leads to the prolonged manufacture of defective devices and gives rise to the possibility of increased losses of materials such as wafers. Recently, manufacturing lines using 300-mm wafers are becoming a reality in semiconductor device manufacturing lines. In such manufacturing lines, it is required to prevent malfunctions as much as possible and respond with greater urgency in the event of a malfunction occurring.

The present invention was achieved in view of the above circumstances, and has as its object to provide a device processing system that can more accurately grasp the operating condition of the device processing apparatus by enabling changes by the user to conditions such as the collection conditions of data used in the device processing apparatus, the processing conditions of statistical processing performed on the collected data, and display conditions when displaying the collected data or the processing result of the statistical processing, and be able to swiftly respond to malfunctions that arise as a result, and an information display method and program.

### MEANS FOR SOLVING THE PROBLEM

The present invention adopts the following constitutions corresponding to the drawings that are shown in the embodiments. Note that the reference numerals in parenthesis given to each component merely indicate examples of the components and are not to be considered as limiting.

To resolve the above-described problems, a device processing system according to the first aspect of the present invention is a device processing system (1) having at least one device processing apparatus (10 to 50) and characterized by being provided with a support device (61) having the following: a data collection condition setting portion (231) that sets collection conditions for collecting data obtained from the device processing apparatus according to a user instruction; a data display condition setting portion (233) that sets display conditions for displaying the data according to the user instruction; a data collection portion (210, 220) that collects from the device processing apparatus data that matches the collection conditions set by the data collection condition setting portion and the display conditions set by the data display condition setting portion; and a display portion that displays the data collected by the data collection portion based on the display conditions set by the data display condition setting portion.

By this invention, data that matches the collection conditions set by the data collection condition setting portion and the display conditions set by the data display condition setting portion are collected from the device processing apparatus, and this data is displayed based on the display conditions set by the data display condition setting portion.

To resolve the above-described problems, a device processing system according to the second aspect of the present invention is a device processing system (1) having at least one device processing apparatus (10 to 50) and characterized by being provided with a support device (61) having the following: a data collection condition setting portion (231) that sets collection conditions for collecting data obtained from the device processing apparatus according to a user instruction; a statistical processing condition setting portion (232) that sets the processing condition of statistical processing performed on the data according to the user instruction; a data collection portion (210, 220) that collects from the device processing apparatus data that matches the collection conditions set by the data collection condition setting portion and the processing conditions set by the statistical processing condition setting portion; a statistical processing portion (250) that performs statistical processing on the data collected by the data collection portion based on the processing conditions set by the statistical processing condition setting portion; and a display portion that displays the processing result performed by the statistical processing portion.

By this invention, data that matches the collection conditions set by the data collection condition setting portion and the processing conditions set by the statistical processing condition setting portion are collected from the device processing apparatus, statistical processing based on the processing conditions set by the statistical processing condition setting portion is performed on the collected data, and the processing result thereof is displayed.

To resolve the above-described problems, a device processing system according to the third aspect of the present invention is a device processing system (1) having at least one device processing apparatus (10 to 50) and characterized by being provided with a support device (61) having the following: a data collection condition setting portion (231) that sets collection conditions for collecting data obtained from the device processing apparatus according to a user instruction; a data display condition setting portion (233) that sets display conditions for displaying the data according to the user instruction; a statistical processing condition setting portion (232) that sets the processing condition of statistical processing performed on the data according to the user instruction; a data collection portion (210, 220) that collects from the device processing apparatus data that matches the collection conditions set by the data collection condition setting portion, the display conditions set by the data display condition setting portion, and the processing conditions set by the statistical processing condition setting portion; a statistical processing portion (250) that performs statistical processing on the data collected by the data collection portion based on the processing conditions set by the statistical processing condition setting portion; and a display portion that displays at least one of the data collected by the data collection portion and the processing result performed by the statistical processing portion based on display conditions set by the data display condition setting portion.

By this invention, data that matches the collection conditions set by the data collection condition setting portion, the display conditions set by the data display condition setting portion, and the processing conditions set by the statistical processing condition setting portion are collected from the device processing apparatus, statistical processing in accordance with the processing conditions set by the statistical processing condition setting portion is performed on the collected data, and at least one of the data collected by the data collection portion and the processing result performed by the statistical processing portion is displayed based on the display conditions set by the data display condition setting portion.

To resolve the above-described problems, a information display method according to the first aspect of the present invention is an information display method that displays information obtained from at least one device processing apparatus (10 to 50), consisting of the following steps: setting the collection conditions to collect data obtained from the device processing apparatus according to a user instruction; setting the display conditions to display the data in accordance with the user instruction; collecting the data that matches the collection conditions and the display conditions that have been set from the device processing apparatus; and displaying the collected data based on the display conditions.

By this invention, the data that matches the collection conditions and the display conditions that have been set are collected from the device processing apparatus, and this data is displayed based on the display conditions that have been set.

To resolve the above-described problems, a information display method according to the second aspect of the present invention is an information display method that displays information obtained from at least one device processing apparatus (10 to 50), consisting of the following steps: setting the collection conditions to collect data obtained from the device processing apparatus according to a user instruction; setting the processing conditions of the statistical processing performed on the data according to the user instruction; collecting the data that matches the collection conditions and the processing conditions that have been set from the device processing apparatus; performing statistical processing on the collected data based on the processing conditions; and displaying the processing result of the statistical processing.

By this invention, the data that matches the collection conditions and the processing conditions that have been set are collected from the device processing apparatus, statistical processing is performed on the collected data based on the set processing conditions, and the processing result is displayed.

To resolve the above-described problems, an information display method according to the third aspect of the present invention is an information display method that displays information obtained from at least one device processing apparatus (10 to 50), consisting of the following steps: setting the collection conditions to collect data obtained from the device processing apparatus according to a user instruction; setting the display conditions to display the data in accordance with the user instruction; setting the processing conditions of the statistical processing performed on the data according to the user instruction; collecting the data that matches the collection conditions, the display conditions, and the processing conditions that have been set from the device processing apparatus; performing statistical processing on the collected data based on the processing conditions; and displaying at least one of the collected data and the processing result of the statistical processing based on the display conditions.

By this invention, the data that matches the collection conditions, the display conditions, and the processing conditions that have been set are collected from the device processing apparatus, statistical processing is performed on the collected data based on the set processing conditions, and at least one of the collected data and the processing result of the statistical processing is displayed based on the set display conditions.

To resolve the above-described problems, an information display program according to the first aspect of the present invention is an information display program that displays information obtained from at least one device processing apparatus (10 to 50), consisting of the following processes: setting the collection conditions to collect data obtained from the device processing apparatus according to a user instruction; setting the display conditions to display the data in accordance with the user instruction; collecting the data that matches the collection conditions and the display conditions that have been set from the device processing apparatus; and displaying the collected data based on the display conditions.

By this invention, the data that matches the collection conditions and the display conditions that have been set are collected from the device processing apparatus, and this data is displayed based on the display conditions that have been set.

To resolve the above-described problems, an information display program according to the second aspect of the present invention is an information display program that displays information obtained from at least one device processing apparatus (10 to 50), consisting of the following processes: setting the collection conditions to collect data obtained from the device processing apparatus according to a user instruction; setting the processing conditions of the statistical processing performed on the data according to the user instruction; collecting the data that matches the collection conditions and the processing conditions that have been set from the device processing apparatus; performing statistical processing on the collected data based on the processing conditions; and displaying the processing result of the statistical processing.

By this invention, the data that matches the collection conditions and the processing conditions that have been set are collected from the device processing apparatus, statistical processing is performed on the collected data based on the set processing conditions, and the processing result is displayed.

To resolve the above-described problems, an information display program according to the third aspect of the present invention is an information display program that displays information obtained from at least one device processing apparatus (10 to 50), consisting of the following processes: setting the collection conditions to collect data obtained from the device processing apparatus according to a user instruction; setting the display conditions to display the data in accordance with the user instruction; setting the processing conditions of the statistical processing performed on the data according to the user instruction; collecting the data that matches the collection conditions, the display conditions, and the processing conditions that have been set from the device processing apparatus; performing statistical processing on the collected data based on the processing conditions; and displaying at least one of the collected data and the processing result of the statistical processing based on the display conditions.

By this invention, the data that matches the collection conditions, the display conditions, and the processing conditions that have been set are collected from the device processing apparatus, statistical processing is performed on the collected data based on the set processing conditions, and at least one of the collected data and the processing result of the statistical processing is displayed based on the set display conditions.

### EFFECTS OF THE INVENTION

According to the present invention, since a user can freely change various conditions such as the collection conditions of data used in the device processing apparatus, the processing conditions of the statistical processing performed on the collected data, the display conditions when displaying the collected data or the processing result of the statistical processing, the data desired by the user can be collected/displayed/analyzed, so that the operation state of the device processing apparatus can be more accurately grasped. As a result, it becomes possible to swiftly respond to the case of a malfunction occurring.

### BRIEF DESCRIPTION OF THE DRAWINGS

FIG. 1 is a block diagram showing the constitution of the device processing system according to an embodiment of the present invention.
FIG. 2 is a drawing showing the schematic configuration of the exposure apparatus.
FIG. 3 is a block diagram showing the main portions of the server of the apparatus support system.
FIG. 4 is a drawing showing an example of the collection conditions setting screen.
FIG 5 is a drawing showing an example of the display conditions setting screen.
FIG 6 is a drawing showing an example of the processing conditions setting screen in the statistical processing.
FIG. 7 is a drawing showing an example of the processing conditions setting screen in the statistical processing.
FIG. 8 is a drawing showing an example of the processing conditions setting screen in the statistical processing.
FIG. 9 is a drawing showing an example of the processing conditions setting screen in the statistical processing.
FIG 10 is a drawing showing an example of an error summary chart.
FIG 11 is a drawing showing an example of a productivity chart.
FIG. 12 is a drawing showing an example of a device environment chart.

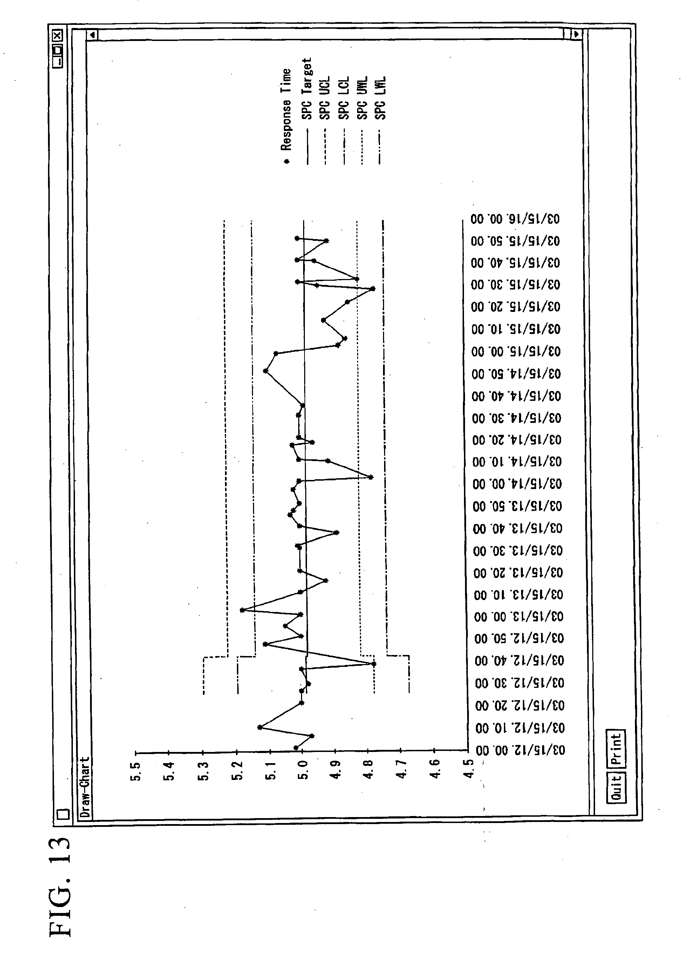

FIG 13 is a drawing showing an example of a setting history display of a judgment threshold value.
FIG 14 is a drawing showing a display example of grouped data.
FIG 15 is a drawing showing an example of a chart showing a processing result of the predictive statistical processing.

### DESCRIPTION OF THE REFERENCE SYMBOLS

1 : device processing system, 10 : exposure apparatus (device processing apparatus), 20 : track (device processing apparatus), 30 : laser (device processing apparatus), 40 : in-line measuring instrument (device processing apparatus), 50 : off-line measuring instrument (device processing apparatus), 60 : apparatus support system, 61 : server (support device), 210 : data collection portion, 220: database engine (data collection portion), 231 : data collection condition setting portion, 232 : statistical processing condition setting portion, 233 : graph display condition setting portion (data display condition setting portion), 250 : application (statistical processing portion)

### BEST MODE FOR CARRYING OUT THE INVENTION

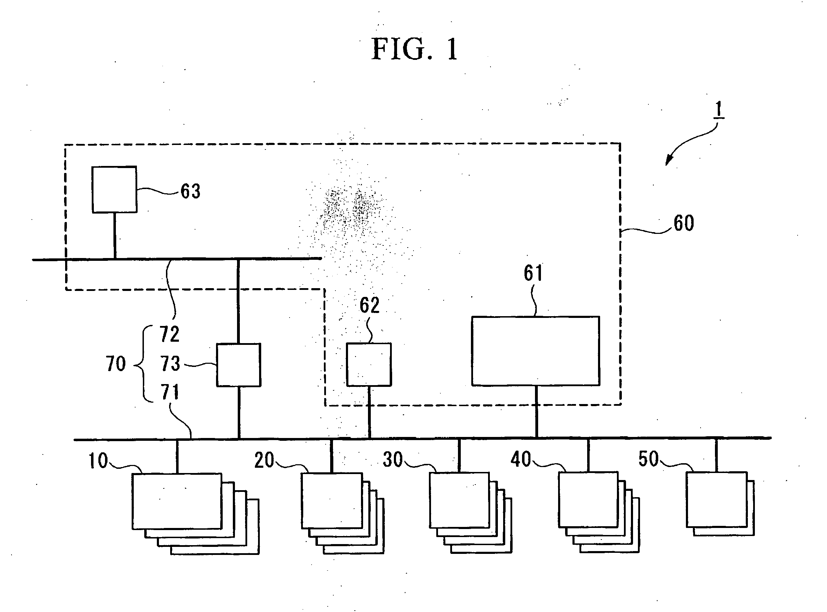

The device processing system and information display method and program of the first embodiment of the present invention are described in detail herein below with reference to the attached drawings. FIG. 1 is a block diagram showing the constitution of the device processing system according to the first embodiment of the present invention. As shown in FIG. 1, a device processing system 1 of the present embodiment is constituted by an exposure apparatus 10, a track 20, a laser 30, an in-line measuring instrument 40 and an off-line measuring instrument 50 serving as inspection devices, an apparatus support system 60, and a communication network 70.

The apparatus support system 60 is constituted by a server 61, a terminal unit 62, and a remote terminal device 63. Also, the communication network 70 is constituted by a first network 71, a second network 72, and a gating arrangement 73. The device processing system 1 is provided with a plurality of device production lines, and so the exposure apparatus 10, the track 20, the laser 30, and the in-line measuring instrument 40 are for example provided in plurality to correspond to each production line. Also, the off-line measuring instrument 50 is provided in plurality apart from the production lines.

First, the constitution of each component of the device processing system 1 will be described in turn. The exposure apparatus 10-i (i=1 to n) (hereinafter referred to simply as the exposure apparatus 10) projects an image with a desired pattern formed on a reticle as a mask upon a wafer serving as a substrate coated with a light-sensitive material to transfer that pattern onto the wafer. In this embodiment, the exposure , apparatus 10 is an exposure apparatus which has an off-axis alignment optical system for detecting patterns of a predetermined standard of the wafer by image processing.

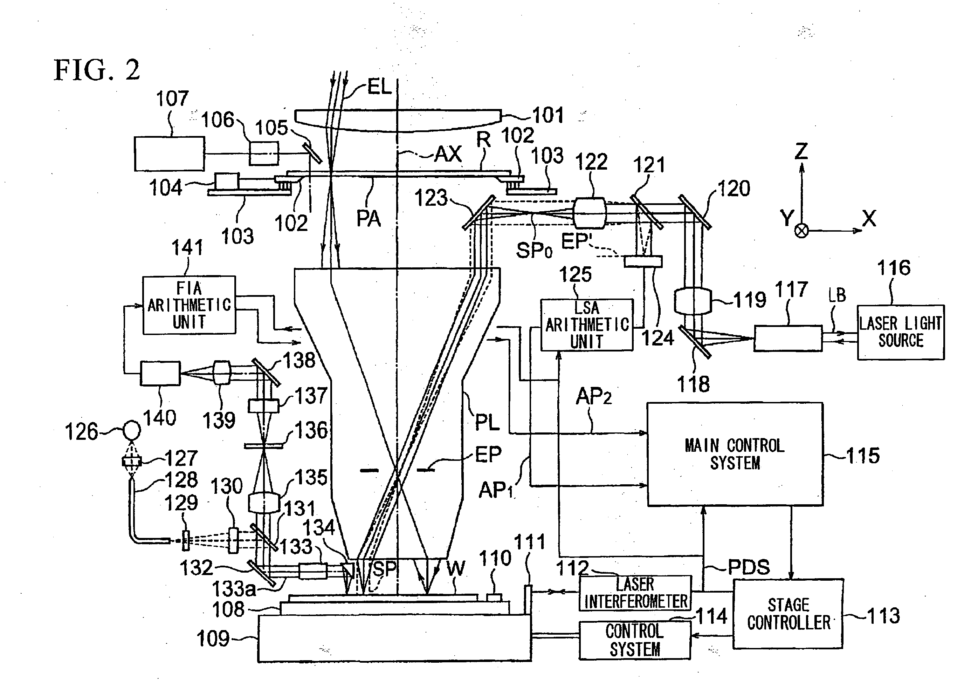

FIG 2 is a drawing showing the skeleton framework of the exposure apparatus. In the description below, a xyz-rectangular coordinate system shown in FIG 2 is established, and the positional relation of the members are given with reference to this xyz-rectangular coordinate system. This xyz-rectangular coordinate system is set so that the x-axis and the z-axis are parallel with respect to the page, and the y-axis is set to a direction that is vertical with respect to the page. The xyz-coordinate system in the drawing is set so that the xy-plane is set to a surface that is parallel to the horizontal surface, and the z-axis is set as vertically upward.

In the exposure apparatus 10, as shown in FIG. 2, exposure light EL emitted from an illumination optical system not shown is irradiated with a uniform illuminance distribution on a pattern area PA formed on a reticle R via a condenser lens 101. Light that is emitted from g-lines (wavelength 436 nm) or i-lines (wavelength 365 nm) or a KrF excimer laser (wavelength 248 nm), an Arf excimer laser (wavelength 193 nm), an F₂ laser (193 nm), a Kr₂ laser (wavelength 146 nm), and an Ar₂ laser (wavelength 126 nm) can be used as the exposure light EL.

The reticle R is held on a reticle stage 102, and the reticle stage 102 is supported so that movement and fine rotation are possible in a two-dimensional plane on a base 103. A main control system 115 that controls the operation of the entire apparatus controls the operation of the reticle stage 102 via a drive unit 104 on the base 103. The reticle R is positioned with respect to optical axis AX of a projection optical system PL by reticle alignment marks, not shown, that are formed in the periphery of the reticle R and detected by a reticle alignment system consisting of a mirror 105, an objective lens 106, and a mark detecting system 107.

Exposure light EL that passes through the pattern area PA of the reticle R enters the telecentric projection optical system PL to be projected onto shot regions on the wafer W. The aberration of the projection optical system PL is optimally corrected in relation to the wavelength of the exposure light EL, and based on the wavelength, the reticle R and the wafer W are mutually coupled. Also, the exposure light EL is Kohler illumination, and is formed as a light source image in the center of an entrance pupil EP of the projection optical system PL. The projection optical system PL has a plurality of optical elements such as lenses. Optical material such as quartz and fluorite corresponding to the wavelength of the exposure light EL is employed as the glass of those optical elements.

The wafer W is mounted on a wafer stage 109 via a wafer holder 108. A reference mark 110 used in baseline measurements and the like is provided on the wafer holder 108. The wafer stage 109 has an xy-stage for two-dimensionally positioning the wafer W in a vertical plane in the optical axis AX of the projection optical system PL, a z-stage for positioning the wafer W in a direction (z-direction) that is parallel to the optical axis AX of the projection optical system PL, and a stage that adjusts the leveling of the wafer W with respect to the xy-plane by changing the angle with respect to the z-axis**.**

An L-shaped traveling mirror 111 is attached to one end of the upper surface of the wafer stage 109, and a laser interferometer 112 is arranged at a position facing the mirror surface of the traveling mirror 111. Although abbreviated in FIG 2, the traveling mirror 111 is constituted by a flat mirror that has a reflective surface that is perpendicular to the x-axis and a flat mirror that has a reflective surface that is perpendicular to the y-axis. Also, the laser interferometer 112 is constituted by two laser interferometers for the x-axis that emit laser beams on the traveling mirror 111 along the x-axis and one laser interferometer for the y-axis that emits a laser beam on the traveling mirror 11 along the y-axis, with the x-coordinate and y-coordinate of the wafer stage 9 being measured by one laser interferometer for the x-axis and one laser interferometer for the y-axis. Also, the angle of rotation of the wafer stage 109 around the z-axis is measured by the difference between the two laser interferometers for the x-axis.

The positional measurement signal PDS that shows the x-coordinate, the y-coordinate, and the rotation angle measured-by the laser interferometer 112 are supplied to a stage controller 113. The stage controller 113 controls the position of the wafer stage 109 via a drive system 114 in correspondence with this positional measurement signal PDS under the control of the main control system 115. Also, the positional measurement signal PDS is output to the main control system 115. The main control system 115, while monitoring the positional measurement signal PDS that is supplied, outputs the control signal that controls the position of the wafer stage 109 to the stage controller 113. In addition, the positional measurement signal PDS that is output from the laser interferometer 112 is output to a laser step alignment (LSA) arithmetic unit 125 described later.

Also, the exposure apparatus 10 has a TTL alignment optical system that consists of a laser light source 116, a beam shaping optical system 117, a mirror 118, a lens system 119, a mirror 120, a beam splitter 121, an objective lens 122, a mirror 123, a, photodetector 124, the LSA arithmetic unit 125, and the projection optical system PL. The laser light source 116 is a light source such as an He-Ne laser and is red light (for example, wavelength 632.8 nm), emitting a non-photosensitive laser beam LB to a coated photoresist on a wafer. This laser beam LB passes the beam shaping optical system 117 that includes a cylindrical lens and the like and enters the objective lens 122 via the mirror 118, the lens system 119, the mirror 120, and the beam splitter 121. Having passed through the objective lens 122, the laser beam LB is reflected by the mirror 123 that is below the reticle R and provided in a tilted direction with respect to the xy-plane. It is then made incident in the vicinity of the field of view of the projection optical system PL parallel with the optical axis AX, and passes through the center of the entrance pupil EP of the projection optical system PL to perpendicularly irradiate the wafer W.

The laser beam LB is focused into a slit-shaped spot light SP₀ in the space of the light path between the objective lens 122 and the projection optical system PL by the working of the beam shaping optical system 117. The projection optical system PL re-images this spot light SP₀ on the wafer as spot SP The mirror 123 is fixed so as to be outside than the perimeter of the pattern area PA of the reticle R and in the field of view of the projection optical system PL. Accordingly, the slit-shaped spot light SP that is formed on the wafer W is positioned outside of the projection image of the pattern area PA.

In order to detect the mark on the wafer W by this spot light SP, the wafer stage 109 is moved horizontally with respect to the spot light SP within the xy-plane. When the spot light SP relatively scans the mark, regular reflection light, scattered light, and diffracted light is generated from the mark, and so the quantity of light changes due to the relative positions of the mark and the spot light SP. This optical information reverses along the sending transmission path of the laser beam LB and reaches the photodetector 124 via the projection optical system PL, the mirror 123, the objective lens 122 and the beam splitter 121. The photo-receiving surface of the photodetector 124 is positioned on an entrance pupil plane EP' that is approximately conjugate with the entrance pupil EP of the projection optical system PL, has a non-sensitive region with respect to the regular reflection light from the mark, and receives only scattered light and diffracted light.

Each photoelectric signal from the photodetector 124 is input to the LSA arithmetic unit 125 together with the positional measurement signal PDS that is output from the laser interferometer 112, and mark position information AP₁ is created. The LSA arithmetic unit 125, based on the positional measurement signal PDS, samples and stores the photoelectric signal waveform from the photodetector 124 when having scanned the wafer mark with the spot light SP, and by analyzing that waveform, outputs the mark position information AP₁ as coordinate information of the wafer stage 109 when the center of the mark matches the center of the spot light SP.

In the exposure apparatus shown in FIG 2, the TTL alignment system (116, 117, 118, 119, 120, 121, 122, 123, and 124) is only shown as one group, but one more group is provided in a direction perpendicular to the page (y-axis direction), and a similar spot light is formed on the projection image surface. Extension lines in the lengthwise direction of these two spot lights head toward the optical axis AX. Also, the solid lines shown in the optical path of the TTL alignment optical system in FIG. 2 show the imaging relation with the wafer W, while the broken lines show the conjugate relation with the entrance pupil EP.

Also, the exposure apparatus 10 provides on the side of the projection optical system PL the off-axis alignment optical system (herein below referred to as the alignment sensor). This alignment sensor is a field image alignment (FIA) alignment sensor that detects position information of the mark by performing signal processing (including image processing) of signals that capture the image in the vicinity of the alignment mark on the substrate surface. In the exposure apparatus 10, this alignment sensor is used to perform search alignment measurement and fine alignment measurement.

Search alignment measurement (herein below sometimes referred to simply as "search alignment") is a process of detecting a plurality of search alignment marks that are formed on a wafer and detecting the rotation with respect to the wafer holder 108 and displacement in the xy-plane. As a signal processing method of search alignment in the present embodiment, using a preset template, a method is used that detects a predetermined pattern corresponding to that template (template matching method). Also, fine alignment measurement (herein below sometimes referred to simply as "fine alignment") is a process of detecting alignment marks for fine alignment that are formed corresponding to the shot regions and ultimately performing positioning of the exposure shots. As a fine alignment image processing method, the present embodiment employs a method that extracts the edge of a mark and performs detection of the position thereof (edge measurement method).

In either of the search alignment and the fine alignment, the image processing method thereof is not limited to the methods of the present embodiment, with the template matching method, the edge measurement method, or another image processing method being applicable. Also, the observation magnification during the above-mentioned search alignment measurement and the observation magnification at the time of fine alignment measurement may be mutually equivalent observation magnifications, or the magnification during fine alignment may be set to be higher than the magnification during search alignment.

This alignment sensor has a halogen lamp 126 that emits illumination light for illuminating the wafer W, a condenser lens 127 that condenses the illumination light emitted from the halogen lamp 126 onto one end of an optical fiber 128, and the optical fiber 128 that guides the illumination light. Using the halogen lamp 126 as a light source of the illumination light means the wavelength band of the illumination light emitted from the halogen lamp 126 is 500 to 800 nm, and since this is a wavelength band that is not sensitive to the coated photoresist on the surface of the wafer W and the wavelength band is wide, the effect of the wavelength characteristics of the reflectance on the wafer W surface can be reduced.

The illumination light emitted from the optical fiber 128 passes through a filter 129 that cuts the photosensitive wavelength (short wavelength) region and the infrared wavelength region of the coated photoresist on the wafer S, and reaches a half mirror 131 via a lens system 130. The illumination light that is reflected by the half mirror 131, after being reflected in a direction nearly parallel with the x-axis by a mirror 132, enters an objective lens 133. It is then further reflected by a prism (mirror) 134 that is fixed so as not to block the field of view of the projection optical system PL at the perimeter of the cylindrical lower portion of the projection optical system PL to perpendicularly irradiate the wafer W.

Although not shown in the drawing, in the optical path from the emission end of the optical fiber 128 to the objective lens 133, a suitable illumination field stop is provided at a position conjugate with the wafer W in relation to the objective lens 133. Also, the objective lens 133 is set in a telecentric system, and the image of the emission end of the optical fiber 128 is formed on the plane 133a of the aperture stop thereof (same as the pupil), and Kohler illumination is performed. The optical axis of the objective lens 133 is determined so as to be perpendicular above the wafer W, so that shifting of the mark position due to inclination of the optical axis during mark detection is prevented.

The reflected light from the wafer W is formed into an image on an index plate 136 by a lens system 135 via the objective lens 133, the mirror 132, and the half mirror 131. This index plate 136 is disposed to be conjugate with the wafer W by the objective lens 133 and the lens system 135 and has linear indicators extending in the X-axis and Y-axis directions. The image of the mark of the wafer W is formed on the index plate 136, and the image of the mark of the wafer W and the index mark are formed on the image sensor 140 via a relay system 137, 139 and a mirror 138. The image sensor 140 (photoelectric conversion means, photoelectric conversion element) converts the image incident on the imaging surface thereof into photoelectric signals (image signal, image data, data, signal), with a two-dimensional CCD for example being used. The signal output from the image sensor 140 (n-dimensional signal) is input to an FIA arithmetic unit 141 together with the positional measurement signal PDS from the laser interferometer 112.

The FIA arithmetic unit 141 detects the alignment mark from the image signal that is input and determines the displacement of the mark image with respect to the index mark of the alignment mark. Then, from the stopped position of the wafer stage 109 that is expressed by the positional measurement signal PDS, the FIA arithmetic unit 141 outputs the information AP₂ regarding the mark center detection position of the wafer stage 109 when the image of the mark formed on the wafer W is accurately positioned in the center of the index mark.

The components of the exposure apparatus 10 operate in conjunction based on the control of the main control system 115. The main control system 115 in this way controls each portion of the exposure apparatus 10. Also, the control system 115 communicates with the server 61 of the apparatus support system 60 described below via the communication network 70 shown in FIG 1. Then, the content (data) of each type of log file, measuring result file, parameter setting file, diagnostic result file, signal waveform file, and several types of trace data recorded in the main control system 115 are transmitted to the server 61.

Here, the aforementioned log files comprise an event log file that records the log of events that occur in the exposure apparatus 10, a sequence log file that records the series of processes performed by the exposure apparatus 10, an error log file that records errors that occur in the exposure apparatus 10, and an operation history log file that records the operation history of the exposure apparatus 10. The measuring result file is a file in which measuring results with using the TTL alignment optical system and the alignment sensor and the like are recorded, while the signal waveform file is a file in which the signals obtained by these sensors are recorded. Also, based on control information obtained by the server 61 of the apparatus support system 60 based on the aforedescribed data, the operating conditions of the main control system 115 are controlled or else operation is stopped or interrupted. The outline constitution of the exposure apparatus 10 is as described above.

The track 20 is a transportation system that successively transports wafers W in each line. This track 20 is controlled by a track server, not shown, for example in the device processing system 1. Also, the laser 30 is a light source that provides exposure light to the exposure apparatus 10 of each line. The in-line measuring instrument 40 is a sensor that is incorporated in a device such as the exposure apparatus 10, the track 20, and the laser 30 and the like, and is a sensor for measuring information such as the ambient temperature, humidity, and air pressure of the device. The data measured by the in-line measuring instrument 40 is output to the server 61 of the apparatus support system 60. The off-line measuring instrument 50 is a measuring tool that is not directly incorporated in the production line of the device, being, for example, a superposition measurement device or a line width measuring device.

The apparatus support system. 60 collects various data via the network 70 from the exposure apparatus 10, the track 20, the laser 30, the in-line measuring instrument 40, and the off-line measuring instrument 50. Also, based on the collected data, it is also possible to control each production line process of the device processing system 1. For that reason, the server 61 of the apparatus support system 60 first collects data from each device such as the exposure apparatus 10, the track 20, the laser 30, the in-line measuring instrument 40, and the off-line measuring instrument 50 and stores it in a database to be managed.

The stored data is then displayed on a display device such as a CRT (cathode ray tube) or liquid crystal display device (not shown), or, using the stored data, statistical processing is performed, and the analysis and diagnostic result of the operating state of a device or a line are displayed on the display device. Also, based on that result, processes such as automatic correction control of each device, report preparation/notification, and the like are performed. Although explained in detail below, the server 61 of the present embodiment is constituted so that collection conditions of data from each device, the data display conditions, the process conditions of statistical processing, and notification conditions of reports can be changed by user instruction.

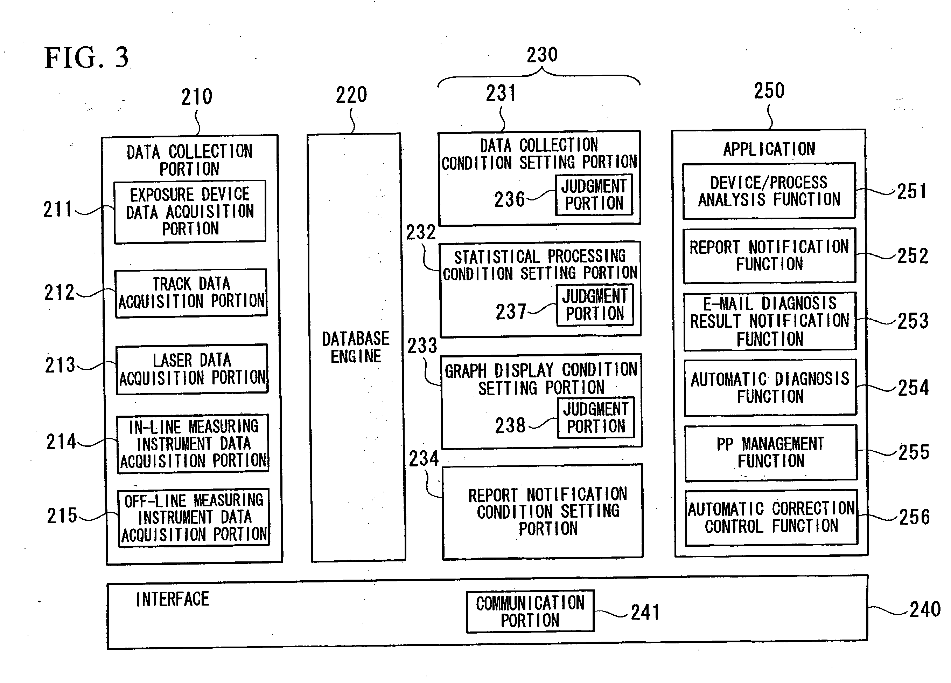

A functional module as shown for example in FIG. 3 is implemented by software or hardware means in the server 61 of the apparatus support system 60, and thereby various device support operations described below are executed. FIG 3 is a block diagram showing the main components of the server 61 of the apparatus support system 60. A data collection portion 210 of the server 61 has an exposure apparatus data acquisition portion 211 that collects data from the exposure apparatus 10, a track data acquisition portion 212 that collects data from the track 20, a laser data acquisition portion 213 that collects data from the laser 30, an in-line measuring instrument data acquisition portion 214 that collects data from the in-line measuring instrument 40, and an off-line measuring instrument data acquisition portion 215 that collects data from the off-line measuring instrument 50.

By means of these data acquisition portions 211 to 215, the event log file, sequence log file, error log file, operation history log file, measuring result file, parameter configuration file, diagnostic result file, file of alignment and other signal waveforms, and other various trace data and log files are collected via the communication network 70 by each device of the device processing system 1 including the exposure apparatus 10 stated above.

A database engine 220 has a database that stores data collected in the data collection portion 210 and a retrieval portion that obtains the necessary data by searching this database. The data that is stored in the database of the database engine 220 is appropriately used by an application 250 described below and provided for support processing of the exposure apparatus. Also, the database engine 220 is also utilized from a terminal device 62 and a remote terminal device 63 described below. Since an enormous amount of data is generally generated by the exposure apparatus 10 compared to other process devices, it is important that the data be efficiently managed by the database engine 220.

Also, the server 61 of the present embodiment is provided with a condition setting portion 230 that sets by user instruction various processes to be performed on data obtained from each device. This condition setting portion 230 is provided with a data collection condition setting portion 231, a statistical processing condition setting portion 232, a graph display condition setting portion 233, and a report notification condition setting portion 234. The data collection condition setting portion 231 sets the collection conditions of data from each apparatus according to user instruction. The statistical processing condition setting portion 232 sets in accordance with the user instruction the processing condition of statistical processing performed on collected data in order to analyze and grasp the operating state of each device.

Also, the graph display condition setting portion 233 sets display conditions for displaying on the display device collected data or data obtained by statistically processing. The report notification condition setting portion 234 sets by user instruction the notification condition of a report that shows at least one of the data collection result from each device, the display result, and the statistical processing result. Note that an input device such as a keyboard or mouse (not shown) is provided in the server 61, with the user instruction being input by operation of the input device. Also, by operating a similar input device that is provided in the terminal device 62, it is possible to input the user's instructions to the server 61 via the communication network 70.

The data collection condition setting portion 231, the statistical processing condition setting portion 232, and the graph display condition setting portion 233 are respectively provided with a judgment portion 236, 237, 238 that judges the consistency of the collected data. These judgment portions 236 to 238 each have a definition file in which are recorded definitions of data consistency. The judgment portions 236 to 238 judges the consistency of data by referring to the respective definition file. The reason why judging the consistency of the data is that displaying data in set displaying condition requires a plurality of data which confirms to set display condition, and that performing statistical processing of data requires a plurality of data which used in set processing conditions, so it must be guaranteed that all needed data which used for the set displaying or set statistical processing have been obtained.

Here, the collection conditions that are set by the data collection condition setting portion 231 include, for example, the collection source, the type of data to be collected, the collection timing of the data (fixed time, fixed cycle, at the occurrence of an event in each device, etc.) and operational expressions (processing methods) in relation to computations performed on data for processing collected data.

The processing conditions that are set by the statistical processing condition setting portion 232 include the type of statistical processing, the operational expression used in the statistical processing, the data condition of data that is subject to the statistical processing, the judgment threshold value to judge at least one of an abnormality and warning with respect to the statistical processing result, and a timing to execute the statistical processing (fixed time, fixed cycle, at the occurrence of an event in each device, etc.). Types of statistical processing include (ordinary) statistical processing to determine the apparatus state until the point the data is obtained, or predictive statistical processing to predict the device state after the point at which the data is obtained. Data conditions of the data that is subject to the statistical processing include an upper limit value and lower limit value of data subject to the statistical processing, or an upper limit value and lower limit value of data not subject to the statistical processing. Also, the aforedescribed judgment threshold value includes an upper limit threshold value and lower limit threshold value for judging an abnormality, or an upper limit threshold value and lower limit threshold value for judging a warning.

The display conditions set by the graph display condition setting portion 233 include the type of graph when graphing the data, the type of data that is subject to display, the group of data that is subject to display, the data conditions of the data that is subject to display, the display timing of data and update timing of the displayed content (fixed time, fixed cycle, at the occurrence of an event in each device, etc.), and the presence of a setting history display of a judgment threshold value to judge at least one of an abnormality and warning with respect to the displayed content. The aforementioned types of graphs include, for example, a bar graph, a line graph, an area graph, a bi-axis graph, a tolerance graph, a pie graph, a drill-down graph, a scatter chart, a three-dimensional bar graph, a three-dimensional area graph, and a three-dimensional scatter chart.

Data conditions of the data that is subject to display include an upper limit value and lower limit value of data that is subject to statistical processing or an upper limit value and lower limit value of data that is not subject to statistical processing. The types of the aforementioned data include collected data, data obtained by statistical calculation, or data obtained by predictive statistical processing. A group of the aforementioned data refers to a state of a plurality of differing data being classified according to predetermined classification criteria. The notification conditions that are set by the report notification condition setting portion 234 set whether to notify as a report any of the data collection results, display results (graphs), and statistical processing results.

An interface 240 is an interface for a server 61 to perform communication with another device and perform input/output of data and commands with the user. Specifically, this interface 240 is provided with a communication portion 241, and provides a communication environment in which the server 61 is connected to another device such as the exposure apparatus 10 via a network 70 to perform transfer of data. Also provided is a remote network connection environment that enables access from the terminal device 62 that is connected via the communication network 70. Also provided is a human interface environment that performs input/output of data and commands from a user in a suitable manner.

The application 250 is a program that realizes functions for the server 61 to perform device support with the exposure apparatus 10 and the like in the device processing system 1. As illustrated, applications for realizing a device/process analysis function 251, a report notification function 252, an e-mail diagnosis result notification function 253, an automatic diagnosis function 254, a PP management function 255, and an automatic correction control function 256 are provided in the server 61 of the present embodiment.

The device/process analysis function 251 performs statistical processing based on processing conditions that are set by the statistical processing condition setting portion 232 on data stored in the database provided in the database engine 220, and outputs the processing result of this statistical processing. At this time, based on the display conditions set by the graph display condition setting portion 233, the processing result is for example output in the form of a graph or chart. This processing result is output to a display device provided in the server 61 or to the display device provided in the terminal device 62 to be graphed. Also, the device/process analysis function 251 performs such actions as totalizing the processing time of each process step, and compiling the target air pressure and actual air pressure of the lens chamber, and outputs these totalization results.

The report notification function 252 is a function that automatically generates and communicates reports that show the operating state of each device of the device processing system 1. The report notification function 252 automatically generates a report based on notification conditions set by the report notification condition setting portion 234, for example, in month, week or day units, and outputs it to a predetermined output destination that is set in advance. The report content is management data for maintaining the proper running state of the device, for example, mean time between failures (MTBF), mean time between interrupts (MTBI), or histograms for each fault generating factor.

The e-mail diagnosis result notification function 253 is a function that transmits the output content and the like of the automatic diagnosis function 254 described below to the remote terminal device 63 at a remote location via a transmission network. Thereby, performance monitoring, ascertainment of malfunctions and stoppages, and judgment of the stoppage region is possible for each device of the device processing system 1 by the remote terminal device 63. As a result, diagnosis and adjustment of the exposure apparatus 10 from a remote place is possible. Also, regular monitoring of operation history and log data enables preventive maintenance of a device.

The automatic diagnosis function 254 is a function that performs statistical processing of data that is collected based on collection conditions set by the data collection condition setting portion 231 and processing conditions set by the statistical processing condition setting portion 232 to automatically detect abnormalities in the operating state of the device. For example, automatic diagnosis such as error number diagnosis, maintenance data diagnosis, or production data diagnosis is performed. Here, error number diagnosis finds device trouble and defective processes from the number of occurrences of errors in the stage, rotor, and alignment of the exposure apparatus 10. The maintenance data diagnosis monitors changes in each type of measurement result of the imaging system, illumination system, alignment, and autofocus, and the like, of the exposure apparatus 10 and thereby performs optimization of the maintenance frequency and optimization of the consumables replacement period. Also, the production data diagnosis monitors the alignment measurement result and the focus control data and the like to perform early detection of process abnormalities and prevent production of defective units. By means of the automatic diagnosis function 254, it is thus possible to shorten downtime and detect abnormalities in production at an early stage or at a suitable timing, and cut down the number of reworked wafers.

The PP management function 255 is a function that manages recipes that disclose actual processing conditions in a device such as the exposure apparatus 10. In the device processing system 1, recipes applied to the exposure apparatus 10 are centrally managed in the server 61 so as to be downloadable from the server 61 to each exposure apparatus 10 or uploadable from each exposure apparatus 10 to the server 61. Also, for that reason the PP management function 255 provides an environment that enables a user to create recipes on the server 61. In other words, the PP management function 255 provides an environment and tools that enable a user to access the server 61 from an office PC and the like via the communication network 70 to create or edit recipes (desktop recipe editing function).

Also, the PP management function 255 provides an environment for optimizing recipes. Normally, a user edits and optimizes recipes based for example on an analysis result or diagnosis result by the device/process analysis function 251 and the automatic diagnosis function 254 described above. However, when editing recipes, there are times when one wishes to otherwise check the adequacy of the processing conditions. The PP management function 255 provides the user with a simulation environment for checking the adequacy of such conditions. In greater detail, the PP management function 255 provides an exposure processing simulation environment based on set recipes, and thereby allows evaluation of, for example, superposition, imaging, and throughput.

The automatic correction control function 256 is a function that performs feedback and feedforward correction control to stabilize the function and operation of a device based on the collection conditions set by the data collection condition setting portion 231, the processing conditions set by the statistical processing condition setting portion 232, or the display conditions set by the graph display condition setting portion 233. The automatic correction control function 256 of the present embodiment, broadly speaking, performs two types of correction control -- correction control for changes in the environment and device state and correction control for processes.

The correction control for changes in the environment and device state attempts to stabilize the device performance by performing correction control on fluctuations in the environment such as temperature, air pressure and humidity and changes in the state of the device such as the track and laser, and the like. Specifically, the following control is, for example, performed. First, predictive control of the focal plane of the exposure apparatus 10 is performed from changes data of the air pressure, temperature, and humidity to improve plane stability (long term focal stability). Also, predictive control of the optimal exposure amount is performed from the change data of the laser, air pressure, temperature, and humidity to improve the critical dimension (CD) stability between wafers (inter-wafer CD change stability). Also, nonuniforimity in the exposure amount of each shot in the wafer attributed to unevenness in the post-exposure bake (PEB) temperature is finely adjusted (controlled) to improve stability of CD changes within a wafer (in-wafer CD change stability). Also, the temperature change of the loader and track interface is measured to predict the amount of expansion and contraction in the wafer during exposure, and alignment correction is performed to improve the superposition accuracy (inter-wafer superposition stability).

The correction control on processes performs stabilization of the device performance by predicting fluctuations attributed to processes and fluctuations due to combinations of devices such as the exposure apparatus, track, and laser and the like during operation, and based thereon performs correction control of various operating conditions and the like. Specifically, the following control is for example performed. For example, optimization of correction parameters in Super Distortion Matching (SDM) and Grid Compensation for Matching (GCM) is performed to improve the superposition accuracy (device matching superposition accuracy improvement). Also, calculation of the actual throughput due to each process recipe (process program) and calculation of the actual throughput between the exposure apparatus and the track are performed, and specification of a throughput reduction unit and support of measures therefor are carried out (productivity increase by throughput simulator). Also, automatic selection of an alignment measuring algorithm for each process is performed to increase the superposition accuracy (alignment measuring algorithm auto measurement). In addition, lens aberration correction control that is optimized corresponding to the mask pattern is performed (lens aberration correction control).

The function operation screen of these application levels is constructed with a web browser, so that regardless of remote/local distinctions, all functions can be utilized from anywhere. The terminal device 62 of the apparatus support system 60 is a terminal device for a user in, for example, a factory to access the server 61. The terminal device 62 is connected to the first network 71 of the communication network 70, and via the first network 71 is connected to the server 61.

The remote terminal device 63 of the apparatus support system 60 is a terminal device for authorized personnel to access the server 61 from, for example, an office outside the factory or the vendor of the exposure apparatus 10. The remote terminal device 63 is connected to the server 61 using the function of the interface 240 of the server 61 via the second network 72, the gating arrangement 73, and the first network 71. The constitution of the apparatus support system 60 is as described above.

The communication network 70 is a network for connecting each device of the device processing system 1. The first network 71 of the communication network 70 is a communication network in, for example, a factory, and connects the server 61 and the terminal device 62 of the apparatus support system 60, the exposure apparatus 10, the track 20, the laser 30, the in-line measuring instrument 40, and the off-line measuring instrument 50. The second network 72 of the communication network 70 is a communication network outside the factory, or a network that the vendor of the exposure apparatus 10 manages. As illustrated, the second network 72 and the first network 71 are connected by the gating arrangement 73 which, for example, functions as a firewall.

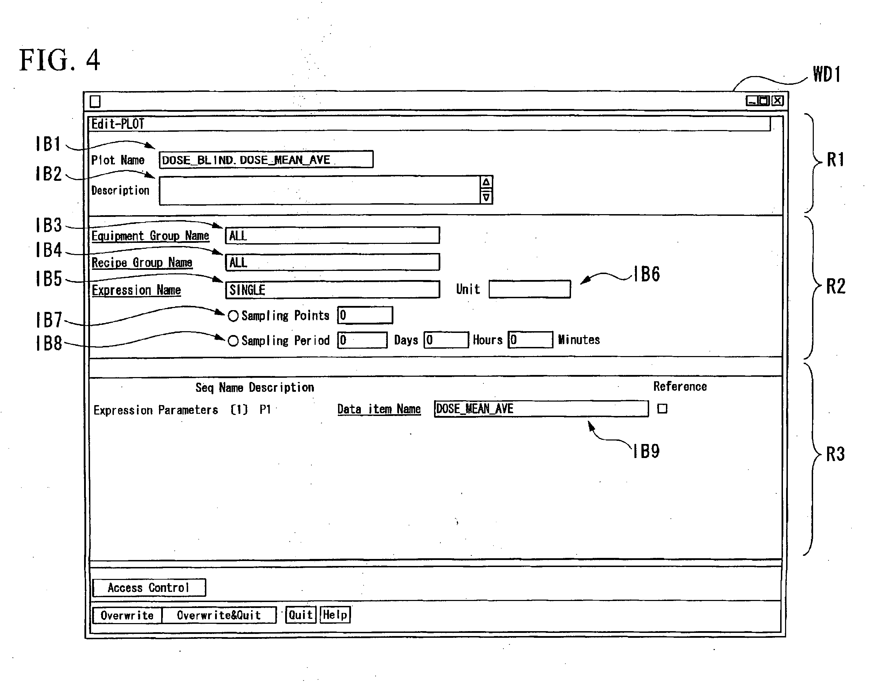

Next, the setting screen of the various conditions mentioned above shall be explained. FIG. 4 is a drawing showing an example of a collection condition setting screen. The collection conditions setting screen is displayed in window WD1 as shown in FIG 4. This window WD1 is broadly divided into three display regions R1 to R3. The display region R3 is a region whose display content changes in accordance with the settings content of the display region R2. The display region R1 has an input field IB1 to input the registered name of a collection condition ("Plot Name") and an input field IB2 to input a comment for the collection condition whose registered name is input in the input field IB1 ("Description").

Here, in order to display the data obtained from a device as a graph, first, when displaying that graph, it is necessary to collect required data. The display and collection of data being related closely. The word "plot" is ordinarily employed in the case of displaying data, and so since the display and collection of data are related closely as described above in the present embodiment, "Plot" is used for the registered name of the collection condition.

The display region R2 has an input field IB3 to input the device group name as the data collection source ("Equipment Group Name"), an input field IB4 to input the recipe group name for the data collection ("Recipe Group Name"), an input field IB5 to input the expression name of the process method (computation) that is performed on the data for processing the collected data ("Expression Name"), an input field IB6 to input the measuring unit of the expression result value ("Unit"), and an input field IB7 to input expression sampling points ("Sampling Points") or an input field IB8 to input the expression sampling period ("Sampling Period").

In the window WD1, the words that are underlined are anchored, and by clicking on an anchor a new window is displayed. For example, by clicking on the anchor of the aforementioned device group name ("Equipment Group Name") that is displayed on the left side of the input field IB3, the device group selection list screen is displayed in a new window (not shown). Similarly, by clicking on the anchor of the aforementioned recipe group name ("Recipe Group Name") that is displayed on the left side of the input field IB4, the recipe group selection screen is displayed a new window (not shown). The content that is selected in each new window is respectively input into the input fields IB3 and IB4. "ALL" is input as the default value in the input fields IB3 and IB4, so that when these fields are left as is, data is collected from all the device groups and all the recipe groups.

Also, by clicking on the anchor that is displayed on the left side of the input field IB5 to input the name of the operational expression (Expression Name), the operational expression selection list screen is displayed in a new window (not shown). The operational expression that is selected in this window is then input into the input field IB5. The default value for the input field IB5 is "SINGLE", so that when left as is, no data processing is performed and the data is displayed as is. Representative operational expression names that can be input in the input field IB5 are as follows:
AVE: Returns the average value of a designated numeric character set
MAX: Returns the maximum value of a designated numeric character set
MIN: Returns the minimum value of a designated numeric character set
COUNT: Returns the number of a designated numeric character set
STDEV: Returns the standard deviation of a designated numeric character set
RANGE: Returns the difference between the maximum value and minimum value of a designated numeric character set
SUM: Returns the sum of a designated numeric character set
ABSMAX: Returns the maximum value of the absolute value of a designated numeric character set
ABSMIN: Returns the minimum value of the absolute value of a designated numeric character set
ABSAVE: Returns the average value of the absolute value of a designated numeric character set
ABSSUM: Returns the sum of the absolute value of a designated numeric character set
SINGLE: Returns a designated variable as is
ABS: Returns the absolute value of a designated number
SIN: Returns the sine of a designated number (unit radian)
COS: Returns the cosine of a designated number (unit radian)
TAN: Returns the tangent of a designated number (unit radian)

In the case of an operation expression intended for one or more data elements (numeric character set), such as "AVE" that determines the average value, being input in the input field IB5, the range of collecting that data is specified by the input content of either input field IB7 or IB8. As shown in FIG. 4, a radio button is provided for the input fields IB7 and IB8, and this radio button is used to exclusively select either one of input fields IB7 and IB8.

An input field IB9 is provided in the display region R3 to input the data item name for the data collection/computation ("Data Item Name"). By clicking the anchor that is shown to the left of the input field IB9, a screen showing a selection list of data items to be calculated (not shown) is displayed in a new window, including such items as a focal following error, a light exposure control error, a synchronous accuracy error, and an alignment error. The item that is selected in this window is then input into the input field IB9. Although FIG. 4 shows only one input field IB9, the number of input fields IB9 that are shown changes in accordance with the input content of the input field IB5 for input of the name of the operational expression ("Expression Name"). Note that although not shown in FIG 4, input fields are also provided to input "Execution Type" and "Next Execution Schedule" that specify the timing to execute data collection. Even if these are not set in the collection conditions setting screen shown in FIG 4, it is possible to perform settings in the processing conditions setting screen or the display conditions setting screen described below. In the case that the "Execution Type" and "Next Execution Schedule" are set in the collection conditions setting screen and either of the processing conditions setting screen or the display conditions setting screen described below, priority is given to the content that is set in the processing conditions setting screen or the display conditions setting screen.

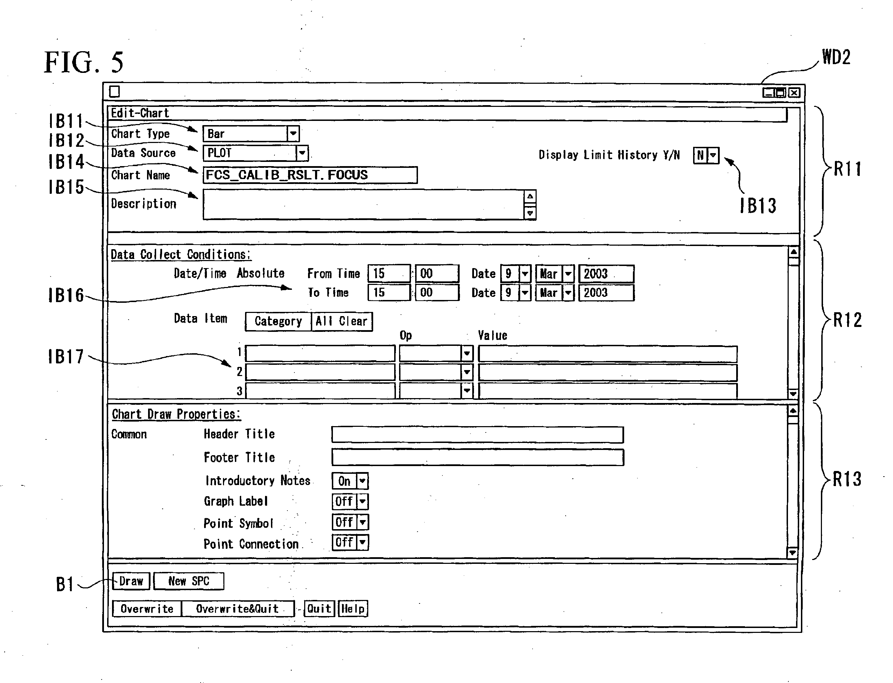

FIG 5 is a drawing showing an example of the display conditions setting screen. The display conditions setting screen is displayed in window WD2 as shown in FIG 5, with this window WD2 being also broadly divided into three display regions R1 to R13 similarly to the above-mentioned window WD1. The display region R11 has an input field IB11 to input the type of chart as the graph type ("Chart Type"), an input field IB12 to input the data source as the type of data to be displayed ("Data Source"), an input field IB13 to designate whether to display the settings history of the judgment threshold value that judges the abnormality/warning of the statistical processing ("Display Limit History Y/N"), an input field IB14 to input a chart name to be the registered name of the display conditions ("Chart Name"), and an input field IB15 to input a comment for the display condition whose registered name is input in the input field IB14 ("Description").

In the input field IB 11, any one of a bar graph, a line graph, an area graph, a bi-axis graph, a tolerance graph, a pie graph, a drill-down graph, a scatter chart, a three-dimensional bar graph, a three-dimensional area graph, and a three-dimensional scatter chart is input as the type of graph. By inputting any one of these, a bar graph, a line graph, an area graph, a bi-axis graph, a tolerance graph, a pie graph, a drill-down graph, a scatter chart, a three-dimensional bar graph, a three-dimensional area graph, or a three-dimensional scatter chart is shown in this field. In the input field IB12, any one of statistical processing, predictive statistical processing, and data collection is input. By inputting one of these, one of the data obtained by statistical processing, the data obtained by predictive statistical processing, and the collected data is displayed. As shown in FIG 5, when "PLOT" is input, the collected data is shown. The input field IB 13 becomes enabled when the input content of the input field IB12 is set to either statistical processing or predictive statistical processing.

The display region R12 is a region to input the data collection condition. The reason for providing the display region R12 to input the collection condition in the screen that sets the display conditions is that the display and collection of data are related closely as stated above. This display region R12 has an input field IB16 to input the period of data that is to be graphed and an input field IB17 to input the attribute data items ("Data Item"). Here, the attribute data item is set to combine the operator and condition value into one condition to restrict the data to be displayed. For example, in the case of designating "EQPID" = "NSR051", the data to be displayed is restricted to data from the device name "NSR051". The representative operational expressions that can be input in the input field IB 17 are as follows.
=: completely agrees with condition value
LIKE: fuzzy retrieval that uses wildcards "*" and "?*"
IN: Agreement with any of the condition values
NOT IN: Non agreement with any of the condition values
**◇**: Outside the condition value
>: Greater than the condition value (not including the condition value)
<: Less than the condition value (not including the condition value)
>=: Greater than the condition value (including the condition value)
<=: Less than the condition value (including the condition value)
BETWEEN: Between condition value 1 and condition value 2 (including condition value 1 and condition value 2)

Although not illustrated in FIG. 5, the display region R12 also has an input field for inputting the data series name ("Data Series Name"), which is the data collection condition name that is subject to statistical processing described hereinbelow, an input field for inputting the execution type ("Execution Type") and next execution schedule ("Next Execution Schedule") that stipulate the display timing of the data, and an input field for inputting the set function for performing grouping of data ("Set Function''). In the case of the input field IB12 being "PLOT", the aforementioned data series name is selected from the registered name of the collection condition that is set in the input field IB1 of window WD1 shown in FIG 1 (i.e., "Plot Name").

The display region R13 has a plurality of input fields to input details related to the graph display when graphing data. For example, a input field to input the title added to the upper portion of the graph ("Header Title") and an input field to input the title added to the bottom portion of the graph ("Footer Title") are provided. In addition, in the case of a two-axis graph of the data, input fields are provided for inputting details such as names of the axes and the interval of the scale.

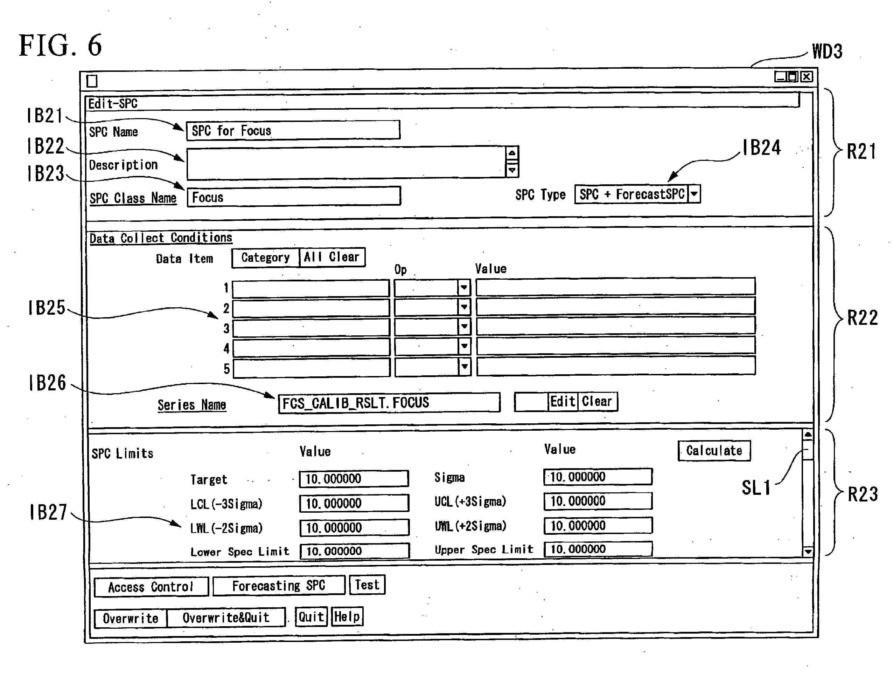

FIGS. 6 to 9 are drawings showing examples of the processing conditions setting screen in the statistical processing. The setting screen for setting the processing conditions of the statistical processing is shown in window WD3 as shown in FIGS. 6 to 9, with this window WD3 being also broadly divided into three display regions R21 to R23 similarly to the above-mentioned windows WD1 and WD2. The contents that are displayed in the display region R23 are numerous, with the contents of the display region R2 not being presentable in a single drawing, and so several drawings will be used to illustrate the window WD3.

The display region R21 has an input field IB2 to input the registered name of the statistical processing ("SPC Name"), an input field IB22 to input a comment for the statistical processing whose registered name is input in the input field IB21 ("Description"), an input field IB23 to input the classification name of the statistical processing ("SPC Class Name"), and an input field IB24 to input the type of statistical processing ("SPC Type"). Here, SPC stands for Statistic Process Control. By clicking on the anchor that is shown on the left side of the input field IB23, the statistical processing classification list screen is displayed in a new window (not shown). The contents shown in this window, in the case of the data collection source being the exposure apparatus, is the class of the focus, exposure amount, synchronous accuracy, alignment, and flatness and the like. In the input field IB24 is input the type of statistical process ((ordinary) statistical process to determine the device state at the time data is obtained, or predictive statistical processing).

The display region R22 is a region to input the data collection condition. The reason for providing the display region R22 to input the collection condition in the screen that sets the statistical processing process conditions is that, similarly to the display and collection of data being related closely, the statistical processing and collection of data are closely related. This display region R21 has an input field IB25 to input the attribute data items ("Data Item") and an input field IB26 to input the data series name ("Data Series Name"), which is the data collection condition name subject to statistical processing.

The attribute data items to be input in the input field IB25 are set to combine the operator and condition value into one condition to restrict the data subject to statistical processing. It is possible to input the same operators as the operators input in the input field IB17 of the display conditions setting screen shown in FIG. 5 (e.g., "=", "LIKE", "IN", etc.) as the operator. Also, by clicking the anchor that is shown to the left of the input field IB26, the data collection condition selection list is shown in a new window (not shown).

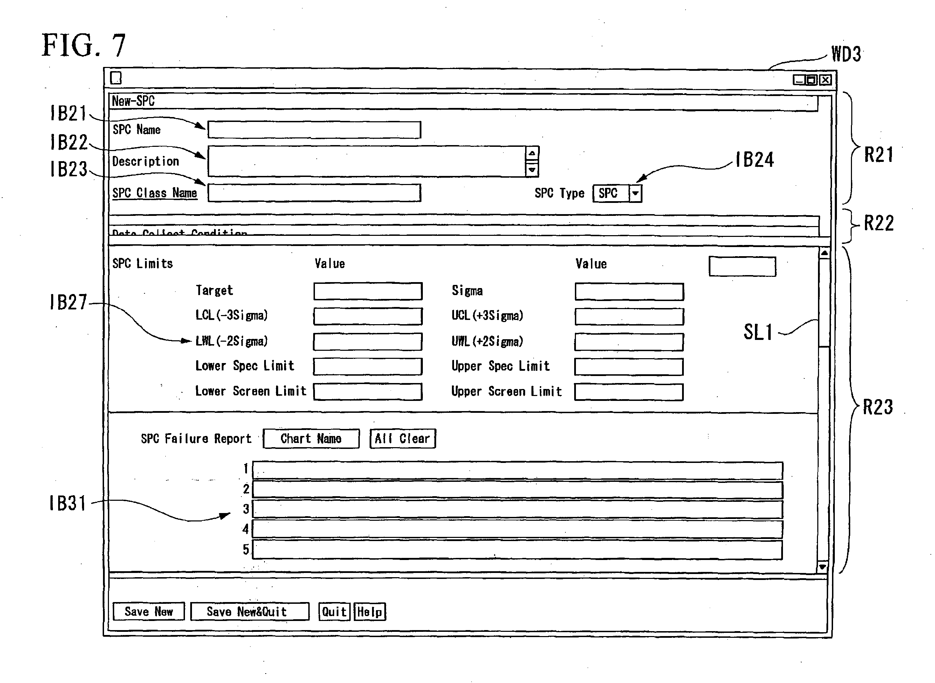

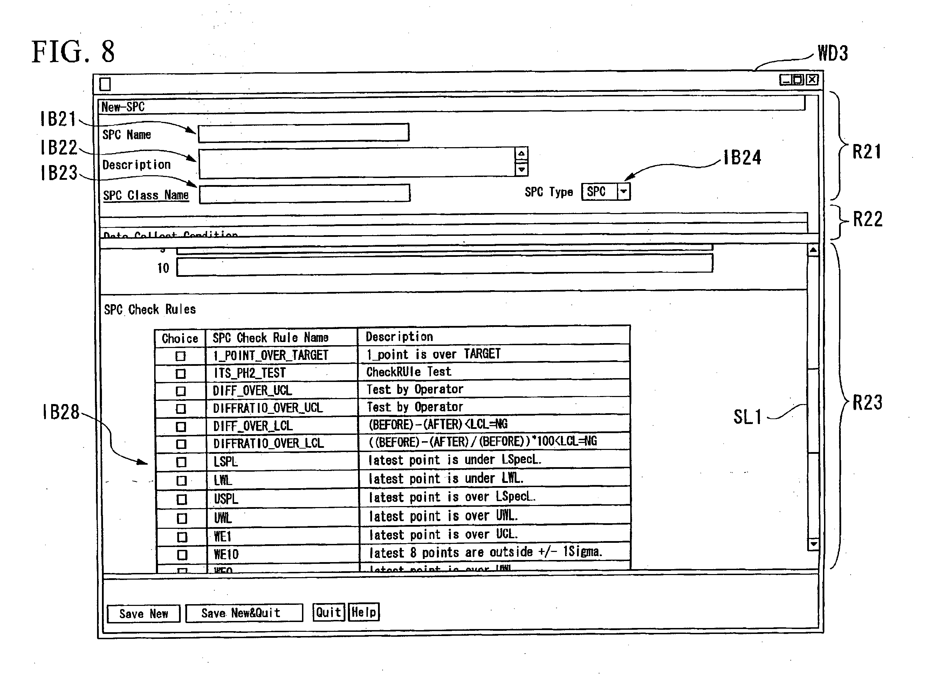

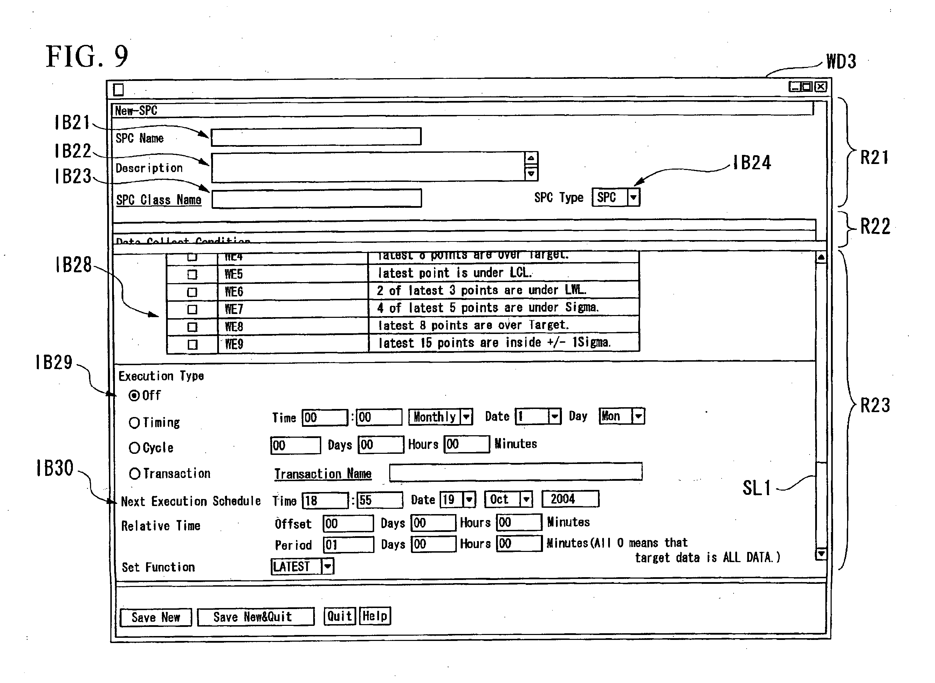

The user can change the display content of the display region R23 as shown in FIGS. 6 to 9 by moving the vertical slider SL1 belonging to the display region R23 vertically (up and down direction in the drawings) with a mouse. This display region R23 has an input field IB27 to input the judgment threshold value for determining an abnormality/warning of the statistical processing ("SPC Limits") (see FIGS. 6 and 7), an input field IB28 to input statistical processing check rules ("SPC Check Rules") (see FIGS. 8 and 9), an input field IB29 to input the execution type ("Execution Type") (see FIG 9), an input field IB30 to input the next execution schedule ("Next Execution Schedule''), and an input field IB31 to input the notification conditions relating to report notification when a statistical processing error occurs (see FIG 7).

The limit threshold value that is input in the input field IB27 sets the upper limit threshold value and lower limit threshold value for judging an abnormality with respect to the result of the statistical processing and sets the upper limit threshold value and lower limit threshold value for judging a warning with respect to the result of the statistical processing. Statistical processing check rules that are registered in advance are input in the input field IB28. It is possible to select a plurality of statistical processing check rules in the input field IB28. The representative statistical processing check rules that can be selected in the input field IB28 are as follows. UCL and LCL shown below are an upper limit threshold value and lower limit threshold value, respectively, for judging an abnormality with respect to the result of the statistical processing, while UWL and LWL are an upper limit threshold value and a lower limit threshold value, respectively, for judging a warning with respect to the result of the statistical processing. An abnormality or warning is judged for the statistical processing result in accordance with the statistical processing check rule input in the input field IB28.
WE1: latest point is over UCL (Upper Control Limit)
WE2: 2 of latest 3 points are over UWL (Upper Warning Limit)
WE3: Four points among five continuous points are over +1σ
WE4: latest 8 points are over target
WE5: latest point is under LWL (Lower Warning Limit)
WE6: 2 of latest 3 points are under LWL (Lower Control Limit)
WE7: 4 of latest 5 points are under -1σ
WE8: latest 8 points are over target
WE9: latest 15 points are inside +/- 1σ
WE10: latest 8 points are outside +/- 1σ

The execution type input in the input field IB29 stipulates the timing for executing the statistical computation process. In the input field IB29, the statistical computation process is set to either of "Off", "Timing", "Cycle", or "Transaction". When "Timing" (i.e., execute at a specific time) is selected, the time for execution, and either of daily, weekly or monthly on a specific day are input. When "Cycle" (i.e., execute periodically) is selected, the time interval is input Also, in the case of "Transaction" (i.e., execution when a transaction occurs) being selected, when the anchor ("Transaction Name") is clicked, the transaction list screen is displayed in a new window (not illustrated), and one of the transactions that is displayed in this window is selected.

In the input field IB30 is input the time and date for executing the next (or first) execution of the statistical computation process. When "Timing" is selected in the input field IB29, data collection is automatically executed at the time designated following the next execution schedule that is input in the input field IB30, When "Cycle" is selected in the input field IB29, data collection is automatically executed at the next execution schedule that is input in the input field IB30, with the data collection being subsequently automatically executed at the designated fixed interval. When "Transaction" is selected in the input field IB29, data collection is automatically executed with the transaction that occurs following the next execution schedule serving as a trigger. Also, the chart name that is to be attached to the report is input as one notification condition related to report notification when a statistical processing error occurs.

In the input of the time and date for executing the statistical computation process above, the content to be input in the input field IB30 is the same regardless of the radio button selection of the input field IB29. However, depending on the selection of "Timing", "Cycle", or "Transaction" in the input field IB29, the interpretation of the content that is input in the input field IB30 differs.

Thus, by making the input field 30 common to the "Timing", "Cycle", and "Transaction" selections in the input field IB29, display area is saved compared to providing input fields corresponding respectively to the "Timing", "Cycle", and "Transaction" in the input field IB29, and so the display content can be simplified.

Also, in the setting screen for the data collection conditions, the data display conditions, and the statistical processing process conditions, an anchor is disposed for each, so that by clicking the anchor, a new window is displayed with a selection list screen displayed therein. The user makes a selection from the choices listed in the selection list screen, and thereby can advance the condition settings.

For example, in optimization of the device manufacturing process, the kinds of information that are handled are enormous. Moreover, completely grasping the name that is given to each on the system is essentially impossible. In such a situation, when setting the data collection conditions, the data display conditions, and the statistical processing process conditions, there is a possibility of human errors being frequently committed such as when simply requested to type a string in an input box that is provided in a setting screen.

In contrast to this, anchors are provided in the setting screen outlined above, so that clicking on an anchor lists choices whose selection is appropriate, thereby hindering errors such as mistakes in typing a string and making unselectable settings.

The setting screens for the data collection conditions, the data display conditions, and the statistical processing process conditions were described above, with the procedure for analyzing the device state using the server 61 next being described. The operations performed by the user are broadly classified into the case of displaying data obtained by a device and the case of performing a diagnostic process on the data obtained by the device and displaying the diagnostic result. Hereinbelow, the operations performed by the user in each case are described in turn.

### (1) The case of displaying data obtained by a device

Initially, the user operates the input device provided in the server 61 and displays the collection conditions display screen shown in FIG 4 to set the collection conditions. Specifically, first the user inputs the registered name of a collection condition ("Plot Name") in the input field IB1, and if required inputs a comment ("Description") for the collection condition whose registered name is input in the input field IB1. Next, the user inputs the device group name ("Equipment Group Name") as the data collection source in the input field IB3, and inputs the recipe group name ("Recipe Group Name") for the data collection in the input field IB4. Moreover, the user inputs the name of the operational expression ("Expression Name") of the process method (computation) that is performed on the data for processing the collected data, inputs the measuring unit ("Unit") of the expression result value in the input field IB6, and inputs the expression sampling points ("Sampling Points") in the input field IB7 or the expression sampling period ("Sampling Period") in the input field IB8. Also, the data item name ("Data Item Name") subject to the computation is designated in the input field IB9. The number of data items designated changes depending on the selected operational expression. By clicking the anchor that is shown to the left of the input field IB9, a selection list of the data items to be calculated (Search Conditions - Data Item Name) screen is displayed in which the data that is to be calculated is listed.

When the above operation is completed, the user displays the display conditions display screen shown in FIG 5 by operating the input device that is provided with the server 61 to set the display conditions. Specifically, the user inputs the type of graph ("Chart Type'') in the input field IB11, and inputs the type of data to be displayed ("Data Source'') in the input field IB12. Next, the user inputs a chart name ("Chart Name") as the registered name of the display conditions in the input field IB14 and inputs a comment ("Description") for the display condition whose registered name is input in the input field IB14 in the input field IB15. Also, in the input field IB13, the user designates whether to display the settings history of the judgment threshold value that judges the abnormality/warning of the statistical processing ("Display Limit History Y/N").

Next, the user inputs the data collection condition in the display region R12 of the window WD2. Specifically, the user inputs the period of data that is to be graphed in the input field IB16 and inputs the attribute data items ("Data Item") in the input field IB17. Moreover, the user also inputs the data series name ("Data Series Name"), which is the data collection condition name to be displayed, the execution type ("Execution Type") and the next execution schedule ("Next Execution Schedule") that stipulate the display timing of the data, and the "Set Function" for performing grouping of data in input fields not shown in FIG 5. In addition, the graph title and the like is input in the display region R13 of the window WD2 as necessary.

When the above condition settings are completed, the user presses the "Draw" button provided in the window WD2 by operating the mouse. Thereby, the data that matches the set collection conditions and the display conditions are collected. In the present embodiment, the data that is used in the apparatus is collected in advance by the data collection portion 210 and recorded in the database of the database engine 220. For this reason, the data that matches the aforesaid collection conditions and display conditions is collected using the database engine 220. Note that the data that matches the set collection conditions and the display conditions may be directly collected from the apparatus via the data collection portion 210 without using the database engine 220. The conformity of the collected data is judged by the judgment portions 236, 238 that are respectively provided in the data collection condition setting portion 231 and the graph display condition setting portion 233.

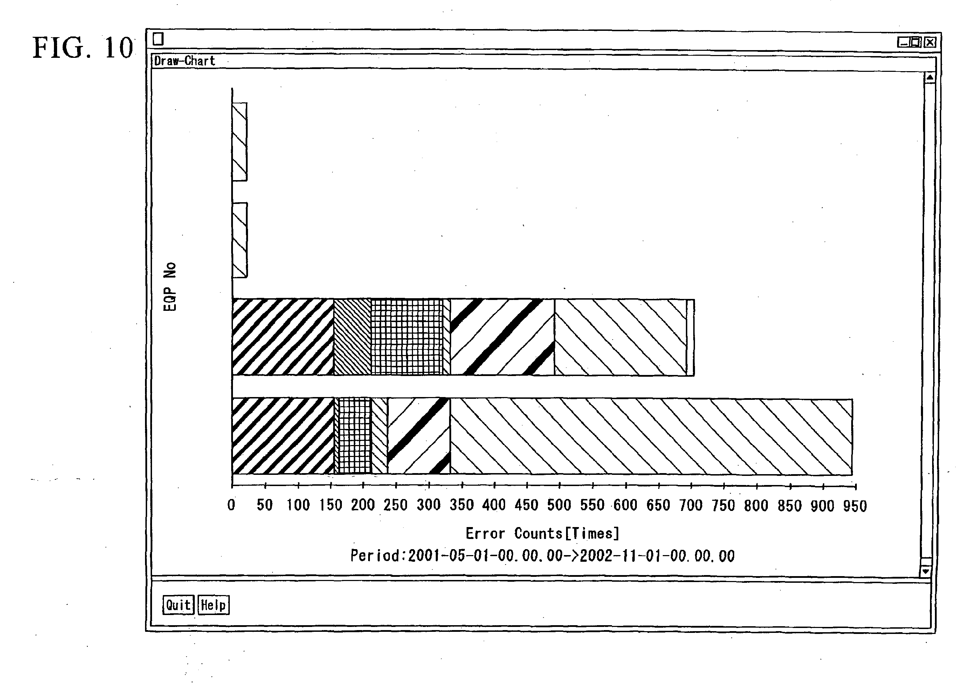

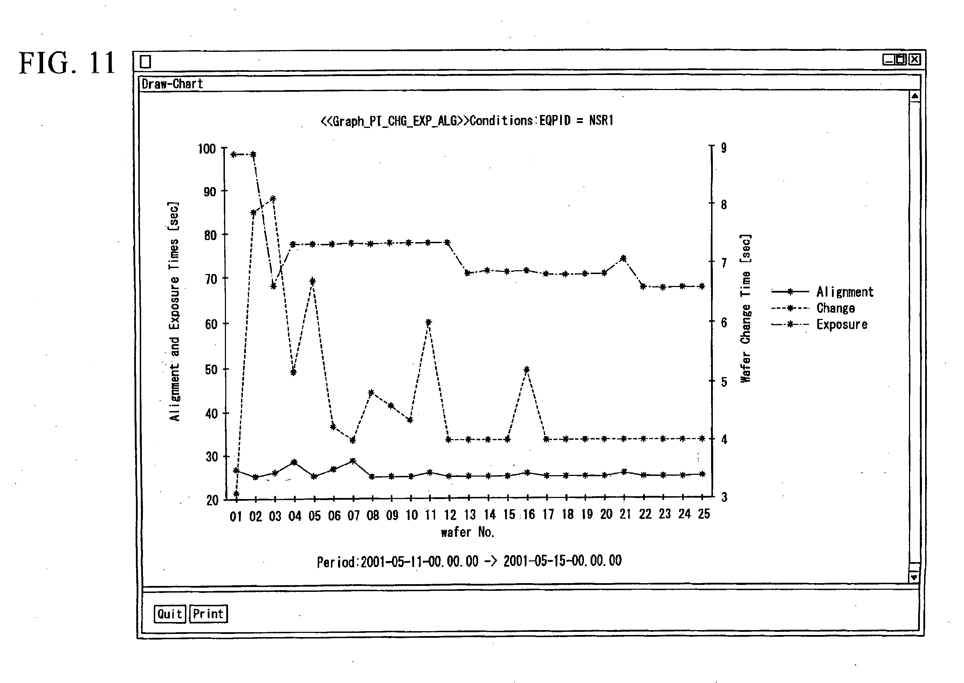

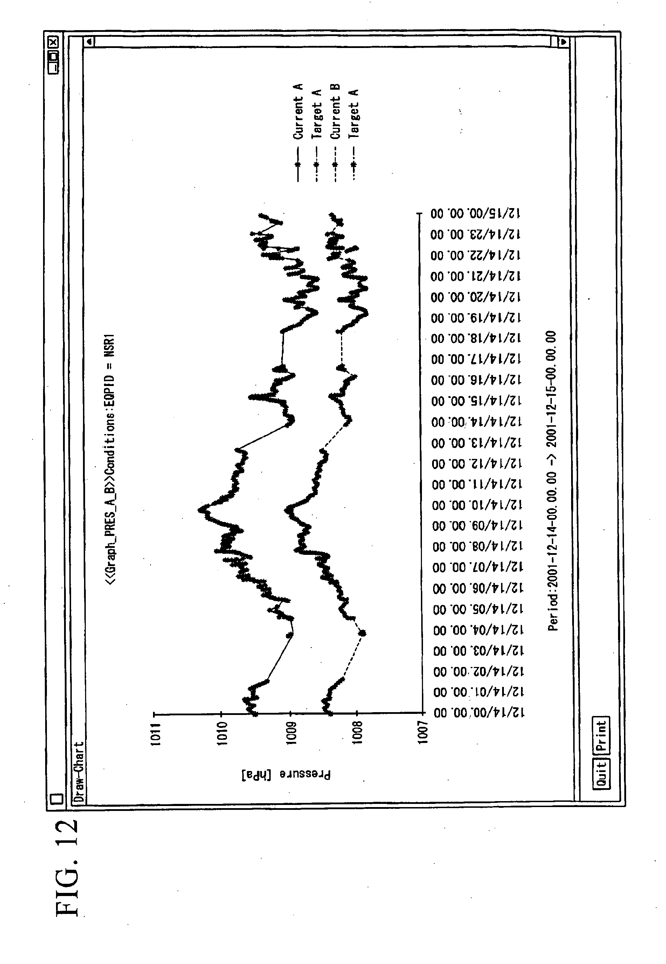

When the data collection is complete, the user's desired graph shown for example in FIGS. 10 to 12 is displayed in the display device of the server 61 (not shown). FIG 10 shows an example of an error summary chart, FIG 11 shows an example of a productivity chart, and FIG 12 shows an example of a device environment chart. The error collection chart shown in FIG 10 is a graph that shows the number of error occurrences in each exposure apparatus 10 during a predetermined period, according to each error type (units of error occurrences). This chart allows one to instantly grasp whether there are problems in a unit of a particular exposure apparatus. That is, it is possible to analyze the dependency of errors on the device and recipe (process, program) and shorten the trouble response time. The productivity chart shown in FIG. 11 is a graph that shows the wafer change time and the alignment and exposure time for each wafer in a lot. From this chart it is evident that there are sometimes wafers with a long wafer change time, causing inefficiency in the wafer transport. In other words, this chart allows one to grasp the utilization state of a device and study measures to increase the productivity.

The device environment chart shown in FIG 12 shows the target air pressure and the measured air pressure for two lens chambers (A and B). From this graph it is evident that the actual air pressure closely tracks the target air pressure for both chamber A and chamber B. Also, in the input field IB 13 "Display Limit History" that is provided in the window WD2 shown in FIG 5, by designating "Y" to display the setting history of the judgment threshold value to judge an abnormality/warning, the relationship between judgment threshold values set in the past and movement of the pressure change can be easily comprehended. These graphs enable one to grasp the environment of the exposure apparatus 10. That is, it is possible to determine the mutual relation between the device performance and environmental fluctuations, shorten the investigation time into the causes of process abnormalities, and optimize the frequency of device adjustment.

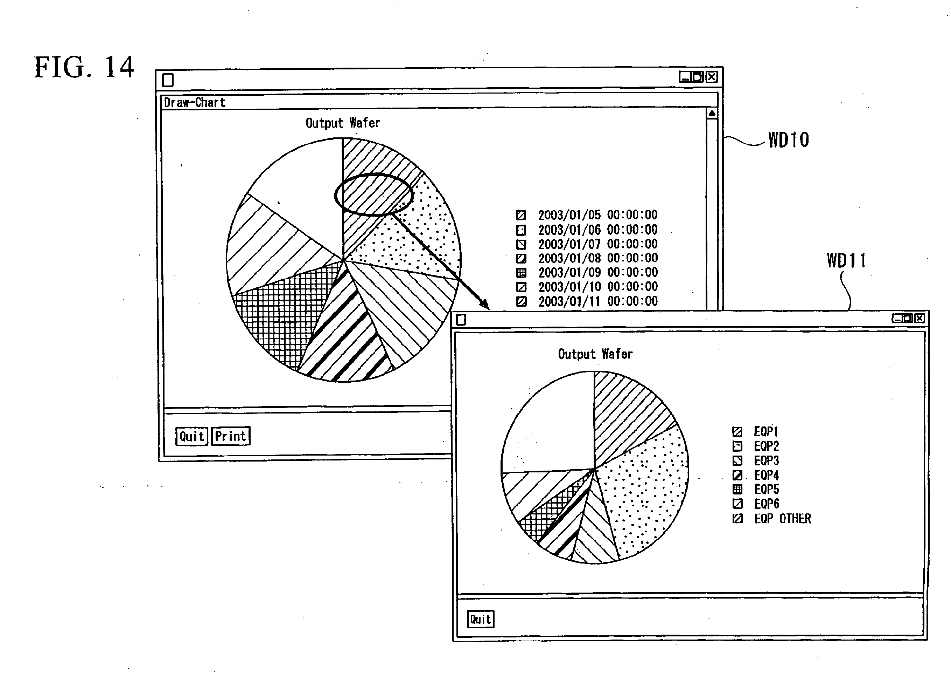

In the case of a set function for grouping data being input in an input field (not shown) that is provided in the display region R12 of the window WD2 shown in FIG 5, the related processing of the grouped data is performed by that set function. FIG 14 is a chart that shows a display example of the grouped data. The graph (drill-down graph) shown in FIG 14 is a display example of data in which the number of processed wafers for each device is grouped. In this display example, window WD10 displays the daily number of processed wafers, and so by selecting a particular date by specifying a portion of this pie graph, the number of processed wafers for each device on that selected date is displayed as a pie graph. Thus, when the data is grouped, a hierarchical graph display becomes possible.

### (2) The case of displaying processing result of a diagnostic process on data

Initially, the user operates the input device provided in the server 61 and displays the collection conditions display screen shown in FIG. 4 to set the collection conditions. Here, the content to be input is the same as the case of displaying the data that is obtained in the device of (1) above. When the above operation is completed, the user displays the processing conditions display screen shown in FIG 6 by operating the input device that is provided with the server 61 to set the processing conditions. Specifically, the user inputs the registered name ("SPC Name") of the statistical processing in the input field IB21 and if necessary inputs a comment ("Description") in the input field IB22 for the statistical processing whose registered name is input in the input field IB21. Next, the user inputs the classification name ("SPC Class Name") of the statistical processing in the input field IB23 and inputs the type of statistical processing ("SPC Type") in the input field IB24.

Next, as the data collection condition in the display region R22, the user inputs attribute data items ("Data Item") to be subject to statistical processing in the input field IB25, and inputs the "Data Series Name" that is the data collection condition name subject to statistical processing in the input field IB26. Next, moving the vertical slider SL1 vertically (up and down direction in the drawings) with a mouse as shown in FIGS. 6 to 9, the user inputs the judgment threshold value ("SPC Limits") for determining an abnormality/warning of the statistical processing in the input field IB27, inputs the statistical processing check rules ("SPC Check Rules") in the input field IB28, inputs the execution type ("Execution Type") in the input field IB29, and inputs the next execution schedule ("Next Execution Schedule") in the input field IB30. Also, if required, the user inputs the notification conditions relating to report notification when a statistical processing error occurs in the input field IB31. Thereby, the collection conditions and the processing conditions are set, and, if required, the display conditions are similarly set.

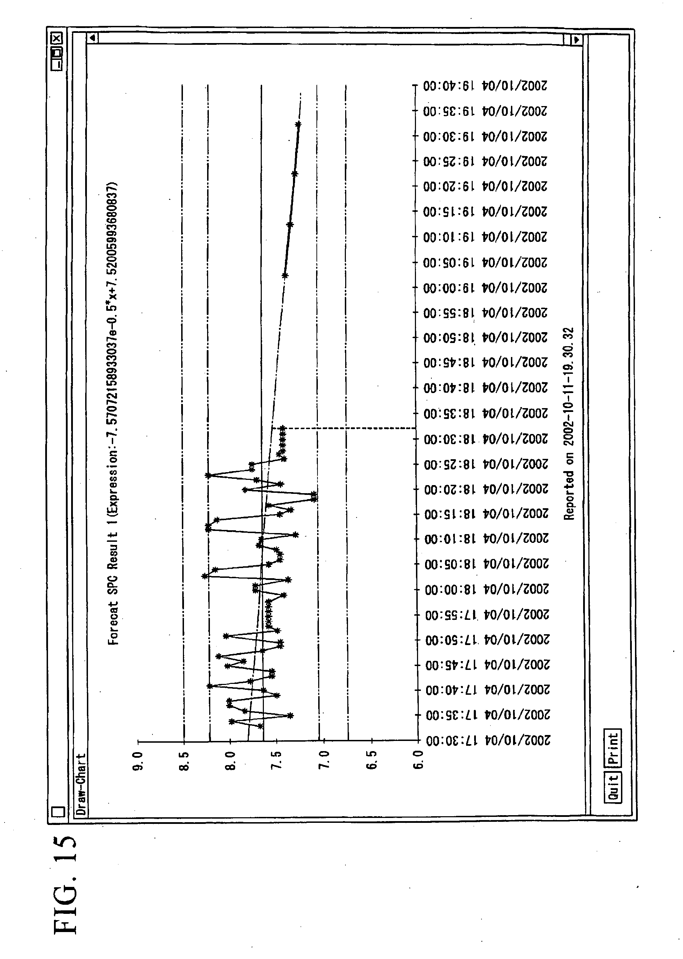

Upon completion of the above conditions settings, when the user performs a predetermined instruction by operating the mouse, the data that matches the collection conditions and the processing conditions that are set (moreover, if display conditions are set, these conditions and the display conditions) are collected and diagnostic processing is performed, whereby the graph desired by the user shown for example in FIG 15 is displayed on the display device (not illustrated) of the server 61. FIG. 15 shows an example of a graph that shows the processing result of the predictive statistical processing. In contrast to ordinary statistical processing that grasps trends at the current point based on past data, the predictive statistical processing predicts trends at a designated period in the future based on a prediction relation (e.g., a primary approximation expression using the least squares method) that is designated based on past data of a designated period/sample number. That is, the period in which an abnormal value may arise is predicted. From this prediction result, the period at which consumable goods should be replaced can be predicted, which can serve as a guide when formulating a maintenance plan. Thereby, the downtime can be shortened.

By operating the device processing system 1 in this way, the user can collect the required data from the data of the processing result in the exposure apparatus 10 to the server 61, the user can perform the required statistical processing, and the user can display the collected data or the processing result of the statistical processing in the required display format. Thereby, the response time from trouble occurrence can be shortened, and efficient production of a device or the like becomes possible. Also, a plurality of display formats can be set with respect to one object data, and thereby, the data can be studied from different angles (different aspects).

While preferred embodiments of the invention have been described and illustrated above, it should be understood that these are exemplary of the invention and are not to be considered as limiting. Additions, omissions, substitutions, and other modifications can be made without departing from the spirit or scope of the present invention. For example, the function of the apparatus support system 60 may be implemented in the exposure apparatus 10 or the in-line measuring instrument 40 and the off-line measuring instrument 50 without installing the apparatus support system 60 separately from the exposure apparatus 10 and the in-line measuring instrument 40. However, since it is conceivable that the load of the device that combines the function of the apparatus support system 60 thereby will increase, from a load standpoint, the aforedescribed embodiment can be said to be preferable. Also, for example, the overall constitution of the device processing system 1 is not limited to the constitution shown in FIG 1, being also applicable to any given process unit without being limited primarily to lithography lines. Also, the device processing apparatus serving as the collection source of the data is not limited to the exposure apparatus 10, and may be, for example, an inspection device that inspects circuits formed on a substrate, an evaluation device that evaluates patterns formed on a substrate, and a repair device that performs repair of circuits formed on a substrate.

Also, the exposure apparatus 10 in the aforementioned embodiment may be an exposure apparatus that uses an immersion method such as disclosed in PCT International Publication No. 99/49504, and may be an exposure apparatus that does not use an immersion method. An exposure apparatus that uses an immersion method may be any one of an immersion-type exposure apparatus that locally fills the space between the projection optical system PL and the wafer with a liquid, an immersion-type exposure apparatus that moves a stage holding the substrate of the exposure target in a liquid reservoir such as disclosed in Japanese Unexamined Patent Application, First Publication No. H06-124873, or an immersion-type exposure apparatus such as disclosed in Japanese Unexamined Patent Application, First Publication No. H10-303114 that forms a liquid tank of a predetermined depth on the stage and holds a substrate therein.

Also, the exposure apparatus 10 described above may be an exposure apparatus that transfers a device pattern used in the manufacture of a semiconductor element onto a semiconductor wafer; an exposure apparatus that is used in the manufacture of a display containing liquid crystal display elements to transfer device patterns onto a glass plate; an exposure apparatus that is used in the manufacture of thin film magnetic heads to transfer a device pattern onto a ceramic wafer, and an exposure apparatus that is used in the manufacture of imaging elements such as CCDs. Moreover, the exposure apparatus may be an exposure apparatus that transfers a circuit pattern on a glass substrate or silicon wafer and the like in order to manufacture a reticle or mask used in an exposure apparatus, an EUV exposure apparatus, an X-ray exposure apparatus, and an electron-beam exposure apparatus. In addition, in the case of providing the functional module shown in FIG. 3 via software, a program for making a computer system execute the functions described above and a recording medium that records this program in a state that can be read and executed by a computer system are included in the present invention.

## Claims

1. A device processing system having at least one device processing apparatus, comprising:
a support device that comprises:
a data collection condition setting portion that sets collection conditions for collecting data according to a user instruction, the data obtained from the device processing apparatus ;
a data display condition setting portion that sets display conditions for displaying the data according to the user instruction;
a data collection portion that collects data from the device processing apparatus, the data matching the collection conditions set by the data collection condition setting portion and the display conditions set by the data display condition setting portion; and
a display portion that displays the data collected by the data collection portion based on the display conditions set by the data display condition setting portion.

2. A device processing system having at least one device processing apparatus, comprising:
a support device that comprises:
a data collection condition setting portion that sets collection conditions for collecting data according to a user instruction, the data obtained from the device processing apparatus;
a statistical processing condition setting portion that sets a processing condition according to the user instruction, the processing condition being for statistical processing on the data;
a data collection portion that collects data from the device processing apparatus, the data matching the collection conditions set by the data collection condition setting portion and the processing conditions set by the statistical processing condition setting portion;
a statistical processing portion that performs statistical processing on the data based on the processing conditions set by the statistical processing condition setting portion, the data collected by the data collection portion; and
a display portion that displays a processing result performed by the statistical processing portion.

3. A device processing system having at least one device processing apparatus, comprising:
a support device that comprises:
a data collection condition setting portion that sets collection conditions for collecting data according to a user instruction, the data obtained from the device processing apparatus;
a data display condition setting portion that sets display conditions for displaying the data according to the user instruction;
a statistical processing condition setting portion that sets the processing condition according to the user instruction, the processing condition being for statistical processing on the data;
a data collection portion that collects from the device processing apparatus data that matches the collection conditions set by the data collection condition setting portion, the display conditions set by the data display condition setting portion, and the processing conditions set by the statistical processing condition setting portion;
a statistical processing portion that performs statistical processing on the data based on the processing conditions set by the statistical processing condition setting portion, the data collected by the data collection portion; and
a display portion that displays at least one of the data collected by the data collection portion and a processing result performed by the statistical processing portion based on display conditions set by the data display condition setting portion.

4. The device processing system according to any one of claims 1 to 3, wherein the data collection condition setting portion sets at least one of a collection source of the data, a type of data to be collected, a collection timing of the data, and a processing method of the collected data, as the collection condition.

5. The device processing system according to claim 4, wherein the collection timing of the data includes at least one of a fixed time, a fixed cycle, and a timing of a processing event in the device processing apparatus from which the data is collected.

6. The device processing system according to claim 4, wherein the setting of the processing method of the collected data is an operational expression setting related to the operation that is performed on the collected data.

7. The device processing system according to claim 2 or 3, wherein the statistical processing condition setting portion sets as the processing condition at least one of a type of the statistical processing, a expression used in the statistical processing, a data condition of the data that is subject to the statistical processing, a judgment threshold value to judge at least one of an abnormality and warning with respect to the statistical processing result, and a timing to execute the statistical processing.

8. The device processing system according to claim 7, wherein the timing to execute the statistical processing includes at least one of a fixed time, a fixed cycle, and at a timing of a processing event in the device processing apparatus from which the data is collected.

9. The device processing system according to claim 7, wherein the type of the statistical processing includes a first statistical processing that determines the apparatus state of the device processing apparatus until the point the data is obtained from the device processing apparatus, and a second processing that predicts the apparatus state of the device processing apparatus after the point at which the data is obtained from the device processing apparatus.

10. The device processing system according to claim 7, wherein the data condition includes at least one of an upper limit value and lower limit value of data subject to the statistical processing, and an upper limit value and lower limit value of data not subject to the statistical processing.

11. The device processing system according to claim 7, wherein the judgment threshold value including at least one of an upper limit threshold value and lower limit threshold value for judging an abnormality with respect to the statistical processing result, and an upper limit threshold value and lower limit threshold value for judging a warning with respect to the statistical processing result.

12. The device processing system according to claim 1 or 3, wherein the display condition setting portion sets as the display condition at least one of a type of graph when graphing the data, a type of data that is subject to display, a group of data that is subject to display, data conditions of the data that is subject to display, a display timing of data and update timing of the displayed content, and a presence of a setting history display of a judgment threshold value to judge at least one of an abnormality and warning with respect to the displayed content.

13. The device processing system according to claim 12, wherein the data conditions includes at least one of an upper limit value and lower limit value of data that is subject to display, and an upper limit value and lower limit value of data that is not subject to display.

14. The device processing system according to claim 12, wherein the graph type includes at least one of a bar graph, a line graph, an area graph, a bi-axis graph, a tolerance graph, a pie graph, a drill-down graph, a scatter chart, a three-dimensional bar graph, a three-dimensional area graph, and a three-dimensional scatter chart.

15. The device processing system according to claim 12, wherein the group of data is in a state of a plurality of differing data being classified according to predetermined classification criteria, and
the display portion, with the group serving as a unit, displays data that is classified in the same group.

16. The device processing system according to claim 12, wherein the display timing of the data and the update timing of the displayed content includes at least one of a fixed time, a fixed cycle, and a timing of a processing event in the device processing apparatus from which the data is collected.

17. The device processing system according to claim 3, wherein the support device sets the notification condition of a report that shows at least one of a data collection result, a display result, and a statistical processing result and is provided with a report output portion that notifies the user of the report based on the notification condition.

18. The device processing system according to any one of claims 1 to 3, wherein the data display condition setting portion allows the setting of a plurality of display conditions, and the display portion performs multifaceted graphing of data that is collected based on the collection conditions that are set by the data collection condition setting portion and the plurality of display conditions.

19. The device processing system according to any one of claims 1 to 3, wherein the display portion, in the case of the group of data that is subject to display being set to the data display condition, displays in a hierarchical manner data related to data classified in the group.

20. The device processing system according to claim 3, wherein the support device automatically optimizes at least one of the collection conditions, the display conditions, and the processing conditions in the case of the judgment threshold value to judge at least one of an abnormality and warning with respect to at least one of the display content and the statistical processing result being set, and when at least one of the display content and the statistical processing result exceeds the judgment threshold value.

21. An information display method for displaying information obtained from at least one device processing apparatus, the method comprising the steps of:
setting collection conditions to collect data obtained from the device processing apparatus according to a user instruction;
setting display conditions to display the data in accordance with the user instruction;
collecting the data that matches the collection conditions and the display conditions that have been set from the device processing apparatus; and
displaying the collected data based on the display conditions.

22. An information display method for displaying information obtained from at least one device processing apparatus, the method comprising the steps of:
setting collection conditions for collecting data obtained from the device processing apparatus according to a user instruction;
setting processing conditions of the statistical processing performed on the data according to the user instruction;
collecting the data that matches the collection conditions and the processing conditions that have been set from the device processing apparatus;
performing statistical processing on the collected data based on the processing conditions; and
displaying the processing result of the statistical processing.

23. An information display method for displaying information obtained from at least one device processing apparatus, the method comprising the steps of:
setting collection conditions for collecting data obtained from the device processing apparatus according to a user instruction;
setting display conditions to display the data in accordance with the user instruction;
setting processing conditions of the statistical processing performed on the data according to the user instruction;
collecting the data that matches the collection conditions, the display conditions, and the processing conditions that have been set from the device processing apparatus;
performing statistical processing on the collected data based on the processing conditions; and
displaying at least one of the collected data and the processing result of the statistical processing based on display conditions.

24. An information display program for displaying information obtained from at least one device processing apparatus, the program consisting of the following processes:
setting collection conditions to collect data obtained from the device processing apparatus according to a user instruction;
setting display conditions to display the data in accordance with the user instruction;
collecting the data that matches the collection conditions and the display conditions that have been set from the device processing apparatus; and
displaying the collected data based on the display conditions.

25. An information display program for displaying information obtained from at least one device processing apparatus, the program consisting of the following processes:
setting collection conditions for collecting data obtained from the device processing apparatus according to a user instruction;
setting processing conditions of the statistical processing performed on the data according to the user instruction;
collecting the data that matches the collection conditions and the processing conditions that have been set from the device processing apparatus;
performing statistical processing on the collected data based on the processing conditions; and
displaying the processing result of the statistical processing.

26. An information display program for displaying information obtained from at least one device processing apparatus, the program consisting of the following processes:
setting collection conditions for collecting data obtained from the device processing apparatus according to a user instruction;
setting display conditions to display the data in accordance with the user instruction;
setting processing conditions of the statistical processing performed on the data according to the user instruction;
collecting the data that matches the collection conditions, the display conditions, and the processing conditions that have been set from the device processing apparatus;
performing statistical processing on the collected data based on the processing conditions; and
displaying at least one of the collected data and the processing result of the statistical processing based on display conditions.

27. A recording medium recorded with an information display program for displaying information obtained from at least one device processing apparatus, wherein the program consists of the following processes:
setting collection conditions to collect data obtained from the device processing apparatus according to a user instruction;
setting display conditions to display the data in accordance with the user instruction;
collecting the data that matches the collection conditions and the display conditions that have been set from the device processing apparatus; and
displaying the collected data based on the display conditions.

28. A recording medium recorded with an information display program for displaying information obtained from at least one device processing apparatus, wherein the program consists of the following processes:
setting collection conditions for collecting data obtained from the device processing apparatus according to a user instruction;
setting processing conditions of the statistical processing performed on the data according to the user instruction;
collecting the data that matches the collection conditions and the processing conditions that have been set from the device processing apparatus;
performing statistical processing on the collected data based on the processing conditions; and
displaying the processing result of the statistical processing.

29. A recording medium recorded with an information display program for displaying information obtained from at least one device processing apparatus, wherein the program consists of the following processes:
setting collection conditions for collecting data obtained from the device processing apparatus according to a user instruction;
setting display conditions to display the data in accordance with the user instruction;
setting processing conditions of the statistical processing performed on the data according to the user instruction;
collecting the data that matches the collection conditions, the display conditions, and the processing conditions that have been set from the device processing apparatus;
performing statistical processing on the collected data based on the processing conditions; and
displaying at least one of the collected data and the processing result of the statistical processing based on display conditions.

30. An exposure apparatus that exposes a predetermined pattern on a substrate, comprising:
a support device that comprises:
a data collection condition setting portion that sets collection conditions for collecting data obtained from the device processing apparatus according to a user instruction;
a data display condition setting portion that sets display conditions for displaying the data according to the user instruction;
a data collection portion that collects from the device processing apparatus data that matches the collection conditions set by the data collection condition setting portion and the display conditions set by the data display condition setting portion; and
a display portion that displays the data collected by the data collection portion based on the display conditions set by the data display condition setting portion.

31. An exposure apparatus that exposes a predetermined pattern on a substrate, comprising:
a support device that comprises:
a data collection condition setting portion that sets collection conditions for collecting data obtained from the device processing apparatus according to a user instruction;
a statistical processing condition setting portion that sets the processing condition of statistical processing performed on the data according to the user instruction;
a data collection portion that collects from the device processing apparatus data that matches the collection conditions set by the data collection condition setting portion and the processing conditions set by the statistical processing condition setting portion;
a statistical processing portion that performs statistical processing on the data collected by the data collection portion based on the processing conditions set by the statistical processing condition setting portion; and
a display portion that displays the processing result performed by the statistical processing portion.

32. An exposure apparatus that exposes a predetermined pattern on a substrate, comprising:
a support device that comprises:
a data collection condition setting portion that sets collection conditions for collecting data obtained from the device processing apparatus according to a user instruction;
a data display condition setting portion that sets display conditions for displaying the data according to the user instruction;
a statistical processing condition setting portion that sets the processing condition of statistical processing performed on the data according to the user instruction;
a data collection portion that collects from the device processing apparatus data that matches the collection conditions set by the data collection condition setting portion, the display conditions set by the data display condition setting portion, and the processing conditions set by the statistical processing condition setting portion;
a statistical processing portion that performs statistical processing on the data collected by the data collection portion based on the processing conditions set by the statistical processing condition setting portion; and
a display portion that displays at least one of the data collected by the data collection portion and the processing result performed by the statistical processing portion based on display conditions set by the data display condition setting portion.

33. A measurement/inspection device that, before or after a substrate is provided to a predetermined device manufacturing process, performs at least one of measuring or inspecting the characteristics of the substrate, comprising:
a support device that comprises:
a data collection condition setting portion that sets collection conditions for collecting data obtained from the device processing apparatus according to a user instruction;
a data display condition setting portion that sets display conditions for displaying the data according to the user instruction;
a data collection portion that collects from the device processing apparatus data that matches the collection conditions set by the data collection condition setting portion and the display conditions set by the data display condition setting portion; and
a display portion that displays the data collected by the data collection portion based on the display conditions set by the data display condition setting portion.

34. A measurement/inspection device that, before or after a substrate is provided to a predetermined device manufacturing process, performs at least one of measuring or inspecting the characteristics of the substrate, comprising:
a support device that comprises:
a data collection condition setting portion that sets collection conditions for collecting data obtained from the device processing apparatus according to a user instruction;
a statistical processing condition setting portion that sets the processing condition of statistical processing performed on the data according to the user instruction;
a data collection portion that collects from the device processing apparatus data that matches the collection conditions set by the data collection condition setting portion and the processing conditions set by the statistical processing condition setting portion;
a statistical processing portion that performs statistical processing on the data collected by the data collection portion based on the processing conditions set by the statistical processing condition setting portion; and
a display portion that displays the processing result performed by the statistical processing portion.

35. A measurement/inspection device that, before or after a substrate is provided to a predetermined device manufacturing process, performs at least one of measuring or inspecting the characteristics of the substrate, comprising:
a support device that comprises:
a data collection condition setting portion that sets collection conditions for collecting data obtained from the device processing apparatus according to a user instruction;
a data display condition setting portion that sets display conditions for displaying the data according to the user instruction;
a statistical processing condition setting portion that sets the processing condition of statistical processing performed on the data according to the user instruction;
a data collection portion that collects from the device processing apparatus data that matches the collection conditions set by the data collection condition setting portion, the display conditions set by the data display condition setting portion, and the processing conditions set by the statistical processing condition setting portion;
a statistical processing portion that performs statistical processing on the data collected by the data collection portion based on the processing conditions set by the statistical processing condition setting portion; and
a display portion that displays at least one of the data collected by the data collection portion and the processing result performed by the statistical processing portion based on display conditions set by the data display condition setting portion.
